# EUROPEAN PATENT SPECIFICATION

(11) **EP 2 692 898 B1**
(45) Date of publication and mention of the grant of the patent: **25.03.2020**
(21) Application number: 12764688.3
(22) Date of filing: 14.02.2012
(51) Int. Cl.: C23C 16/455, C23C 16/54, H01J 37/32

(54) **PLASMA CVD APPARATUS AND PLASMA CVD METHOD**
PLASMA-CVD-VORRICHTUNG UND PLASMA-CVD-VERFAHREN
APPAREIL CVD PAR PLASMA ET PROCÉDÉ CVD PAR PLASMA

(30) Priority: 31.03.2011 JP 2011077708; 31.03.2011 JP 2011077709; 31.03.2011 JP 2011077710
(43) Date of publication of application: 05.02.2014
(73) Proprietor: Toray Industries, Inc., Tokyo, 103-8666 (JP)
(72) Inventor: EJIRI, Hiroe, Shiga 5208558 (JP); SAKAMOTO, Keitaro, Shizuoka 4110824 (JP); NOMURA, Fumiyasu, Shiga 5208558 (JP); UEDA, Masanori, Shizuoka 4110824 (JP)
(74) Representative: Hoefer & Partner Patentanwälte mbB
(86) International application number: PCT/JP2012/053403
(87) International publication number: WO 2012/132588

(56) References cited:
- EP-A1- 2 123 793
- EP-A2- 0 523 609
- JP-A- 3 166 366
- JP-A- 9 228 054
- JP-A- 10 298 764
- JP-A- 2002 115 046
- JP-A- 2005 330 553
- JP-A- 2007 323 820
- JP-A- 2008 169 434
- JP-A- 2010 095 735
- US-A1- 2011 064 890

## Description

### Technical Field

This invention relates to a plasma CVD apparatus wherein plasma is generated in the gap between a long substrate and a plasma generation electrode, and chemical reaction of the source gas is promoted by using the thus generated plasma to thereby form a thin film on the surface of the long substrate. This invention also relates to a plasma CVD method.

### Background Art

Various types of plasma CVD apparatus and plasma CVD methods have been proposed. In these plasma CVD apparatus and plasma CVD methods, a DC power, a radio frequency power, or the like is applied to the plasma generation electrode for plasma generation in a vacuum chamber where a long substrate such as a polymer film substrate can be conveyed, and chemical reaction of the source gas is promoted by the thus generated plasma to thereby form the desired thin film. In the meanwhile, reactive sputtering method is a technique wherein target atoms ejected by sputtering are allowed to undergo reaction with a gas such as oxygen or nitrogen for deposition of the reaction product on the substrate as a thin film. Both CVD and reactive sputtering methods are capable of forming a film of oxide and nitride.

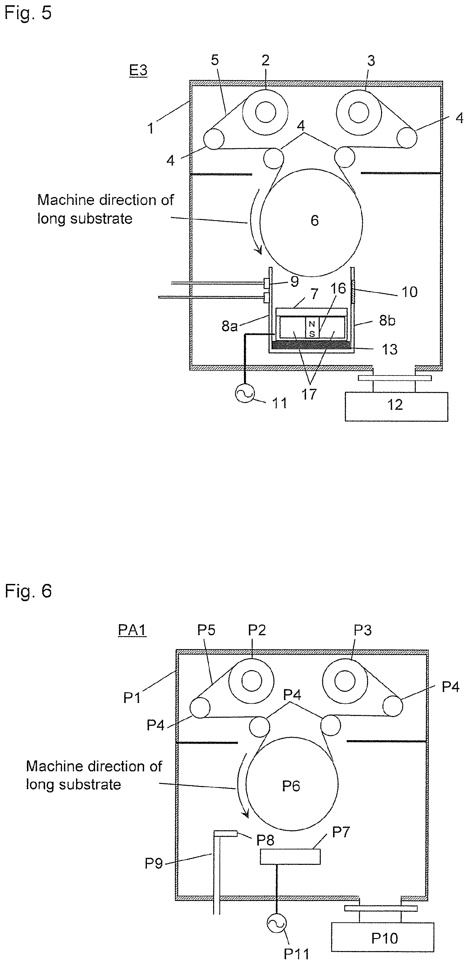

An exemplary conventional plasma CVD apparatus adapted for use with a long substrate is described by referring to FIG. 6. In a vacuum chamber P1, a long substrate (substrate sheet) P5 is conveyed from a feed roll P2 to guide rolls P4, a main roll P6, another set of guide rolls P4, and a takeup roll P3 in this order. A plasma generation electrode P7 is provided near the main roll P6. The source gas is supplied through a pipe line P9 to a nozzle P8, and then introduced from this nozzle P8 to the space between the main roll P6 and the plasma generation electrode P7. When electricity is applied to the plasma generation electrode P7 by a power supply P11, plasma is generated between the plasma generation electrode P7 and the main roll P6, and the source gas is decomposed. The substance used for the film deposition is thereby generated. A thin film is continuously formed on the surface of the long substrate P5 conveyed by the main roll.

Patent document 1 discloses an apparatus wherein the plasma generation electrode used is a mesh electrode placed in a box-shaped reaction tube (reaction chamber) which is open only on the side opposing the main roll. Magnets are also provided in the main roll on the side of the reaction tube and on the mesh electrode at the side opposite to the main roll to thereby generate a magnetic field in the film deposition space to thereby form a high density plasma and increase film deposition speed of the DLC (diamond like carbon) film.

In patent document 2, a magnet is also provided in the interior of the plasma generation electrode, and an injection hole for generating hollow cathode discharge is further provided on the plasma generation electrode on the side opposing the cooling drum. Damages done to the long substrate is suppressed by focusing the plasma to the surface of the plasma generation electrode.

In the plasma CVD, the decomposition of the source gas by the plasma is associated with the formation of particles (dusts) by coagulation and solidification of the components not used in the film deposition. Entering of these particles in the thin film during the deposition results in the poor film quality and these particles also deform shape of the discharge electrode surface by depositing on the surface of the discharge electrode. The deformation of the discharge electrode surface by the deposition of the particles on the surface results in the change of the electric field generated between the discharge electrode and the substrate, and hence, in the loss of the consistency in the film deposition speed and the film quality. In addition, more frequent cleaning of the apparatus will be required for the removal of the particles, and this results in the reduced productivity. The situation is similar in the reactive sputtering, and in the reactive sputtering of an insulator material, the insulator material is deposited also on the target surface with the progress in the sputtering, and this leads to change in the electric field on the target surface, causing problems such as the loss of film consistency and generation of arc discharge.

In the patent document 1, the source gas is supplied to the reaction tube, and decomposed by the plasma for the deposition. The gas that was not used in the film deposition is exhausted to the exterior of the vacuum chamber by a gas exhaust apparatus. For the prevention of the inclusion of the particles in the deposited film, it would be effective if the particles generated in the gas phase are exhausted before reaching the substrate. However, patent document 1 does not clearly describe such exhausting method. In addition, the gas is supplied in the patent document 1 from the vertically lower side of the substrate, and according to the findings of the inventors of the present invention, such gas supply method promotes deposition of the particles generated in the plasma on the substrate. On the other hand, particles are less likely to be collected toward the substrate when the gas is supplied and exhausted in the direction substantially parallel to the substrate.

In the case of patent document 2, maintenance of the interior of the vacuum chamber at a pressure of up to 1 Pa in view of suppressing the particle generation in the gas phase is disclosed. Patent document 2, however, does not disclose any structural countermeasure for the particles. In addition, the source silane compound is supplied in the patent document 2 from a source introduction pipe (source gas injector member). Provision of such protrusion like a pipe near the plasma area may cause abnormal discharge especially in the use of radio frequency power.
Finally, a plasma CVD apparatus according to the preamble portion of claim 1 is known from patent document 3.

### Prior Art document

### Patent document

Patent document 1: JP H10-251851 A
Patent document 2: JP 2008-274385 A
Patent document 3 : EP 0 523 609 A2

### Summary of the Invention

### Technical Problem

In view of the situation as described above, an object of the present invention is to provide a plasma treatment apparatus and method for depositing a thin film on a surface of a long substrate while the long substrate is being conveyed, wherein abnormal discharge is reduced, surface contamination of the electrode and the target is suppressed, and the film deposition speed and film quality are consistent.

### Solution to Problem

In order to achieve the object as described above, the present invention provides a plasma CVD apparatus as described below.

The present invention provides a plasma CVD apparatus comprising a vacuum chamber, and a main roll and a plasma generation electrode in the vacuum chamber, wherein a thin film is formed on a surface of a long substrate which is being conveyed along the surface of the main roll; wherein at least one side wall extending in the transverse (width) direction of the long substrate is provided on each of the upstream and downstream sides of the machine (conveying) direction the long substrate, and the side walls surrounds the space between the main roll and the plasma generation electrode where the thin film is formed; the side walls are electrically insulated from the plasma generation electrode; and the side wall on either the upstream or the downstream side in the machine direction of the long substrate is provided with a gas supply hole.

Further, the gas supply hole is in the form of a row of gas supply holes aligned in the transverse direction of the long substrate, and wherein at least one row of the gas supply holes is provided. The term "row" in the present invention include the cases wherein some gas supply holes are deviated from the central axis of the row of the gas supply holes such that the distance between the central axis of the row and the center of the deviated gas supply hole is up to several times the diameter of the gas supply hole, and for example, the gas supply holes are referred to as the row even if the gas supply holes are microscopically in grid arrangement or in random arrangement, as long as the gas supply holes can be macroscopically regarded a row.

In addition, the side wall on either the upstream or the downstream side in the machine direction of the long substrate which is not the one provided with the gas supply hole is provided with a gas exhaust opening, and the gas exhaust opening has a plurality of gas exhaust holes.

Also provided is a plasma CVD apparatus which is any one of the plasma CVD apparatus as described above, wherein the row of the gas supply holes is provided in the side wall on the upstream side in the machine direction of the long substrate, and the gas exhaust opening is provided in the side wall on the downstream side in the machine direction of the long substrate.

Also provided is a plasma CVD apparatus which is any one of the plasma CVD apparatus as described above, wherein at least two rows of the gas supply holes are provided, and at least the row of the gas supply holes nearest to the plasma generation electrode is capable of supplying a gas different from the gas supplied by other rows of the gas supply holes.

Also provided is a plasma CVD apparatus which is any one of the plasma CVD apparatus as described above, wherein a magnet for generating magnetic flux on the surface of the plasma generation electrode is in the plasma generation electrode.

The present invention also provides a plasma CVD method conducted by using any one of the plasma CVD apparatus as described above comprising the steps of supplying a source gas from the gas supply hole or the row of the gas supply holes, and generating plasma from the plasma generating electrode to form a thin film on the long substrate being conveyed.

Also provided is a plasma CVD method conducted by using the plasma CVD apparatus as described above; wherein the plasma CVD apparatus used is a plasma CVD apparatus wherein at least two rows of the gas supply holes are provided, and at least the row of the gas supply holes nearest to the plasma generation electrode is capable of supplying a gas different from the gas supplied by other rows of the gas supply holes; and wherein the gas supplied from at least the row of the gas supply holes nearest to the plasma generation electrode is different from the gas supplied by other rows of the gas supply holes.

Also provided is a plasma CVD method using the plasma CVD apparatus as described above, wherein the gas supplied from the row of the gas supply holes nearest to the plasma generation electrode is only a non-reactive gas, and a gas containing Si atom or C atom in the molecule is supplied from at least one of other rows of the gas supply holes, and plasma is generated by the plasma generation electrode to thereby form a thin film on the long substrate being conveyed.

### Advantageous Effects of Invention

The present invention provides a plasma CVD apparatus for depositing a thin film on a surface of a long substrate while the long substrate is being conveyed, wherein abnormal discharge is reduced, contamination of the electrode surface is suppressed, and consistency of the film deposition speed and quality is secured. Use of the plasma CVD apparatus of the present invention enables production of a high quality thin film with reduced deficiency since inconsistency in the film deposition speed and the film quality by the contamination of the electrode surface can be suppressed, and in particular, since the film can be deposited under the condition wherein film contamination with high molecular weight substances and particles unnecessary for the plasma CVD is suppressed.

### Brief Description of Drawings

[FIG. 1] FIG. 1 is a schematic cross sectional view of the plasma CVD apparatus according to an embodiment of the present invention.
[FIG. 2] FIG. 2 is an enlarged perspective view of the plasma generation electrode section of the plasma CVD apparatus according to an embodiment of the present invention.
[FIG. 3] FIG. 3 is an enlarged perspective view of the gas supply section of the plasma CVD apparatus according to an embodiment of the present invention.
[FIG. 4] FIG. 4 is a schematic cross sectional view showing another embodiment of the plasma CVD apparatus of the present invention.
[FIG. 5] FIG. 5 is a schematic cross sectional view showing further embodiment of the plasma CVD apparatus of the present invention.
[FIG. 6] FIG. 6 is a schematic cross sectional view showing an embodiment of the conventional plasma CVD apparatus.
[FIG. 7] FIG. 7 is an enlarged perspective view of the plasma generation electrode section of the plasma CVD apparatus according to the further embodiment of the present invention.
[FIG. 8] FIG. 8 is a schematic cross sectional view of the plasma CVD apparatus according to an embodiment of the present invention.
[FIG. 9] FIG. 9 is an enlarged perspective view of the plasma generation electrode section of the plasma CVD apparatus according to an embodiment of the present invention.
[FIG. 10] FIG. 10 is a schematic view showing an embodiment of the side wall on the downstream side in the machine direction of the long substrate of the present invention.
[FIG. 11] FIG. 11 is a schematic view showing another embodiment of the side wall on the downstream side in the machine direction of the long substrate of the present invention.
[FIG. 12] FIG. 12 is a horizontal cross sectional view showing the interior of the plasma generation electrode of the present invention.
[FIG. 13] FIG. 13 is a schematic view showing another embodiment of the side wall on the upstream side in the machine direction of the long substrate of the present invention.
[FIG. 14] FIG. 14 is a schematic view showing another embodiment of the side wall on the upstream side in the machine direction of the long substrate of the present invention.
[FIG. 15] FIG. 15 is a schematic view showing the side wall on the upstream side in the machine direction of Comparative Example.
[FIG. 16] FIG. 16 is a schematic view showing the side wall on the upstream side in the machine direction of Comparative Example.
[FIG. 17] FIG. 17 is a schematic cross sectional view of the reactive sputtering apparatus according to an example.
[FIG. 18] FIG. 18 is an enlarged perspective view of the plasma generation electrode section of the reactive sputtering apparatus according to an example.
[FIG. 19] FIG. 19 is a schematic cross sectional view of the reactive sputtering apparatus according to another example.
[FIG. 20] FIG. 20 is an enlarged perspective view of the plasma generation electrode section of the reactive sputtering apparatus according to anotherexample.
[FIG. 21] FIG. 21 is a schematic cross sectional view of the reactive sputtering apparatus according to further example.
[FIG. 22] FIG. 22 is an enlarged side elevational view of the gas supply section of the reactive sputtering apparatus according to an example.

### Description of Embodiments

Next, the present invention is described by referring to the drawings of the best embodiment of the present invention wherein the present invention has been applied for a plasma CVD apparatus capable of forming a silicon oxide film.

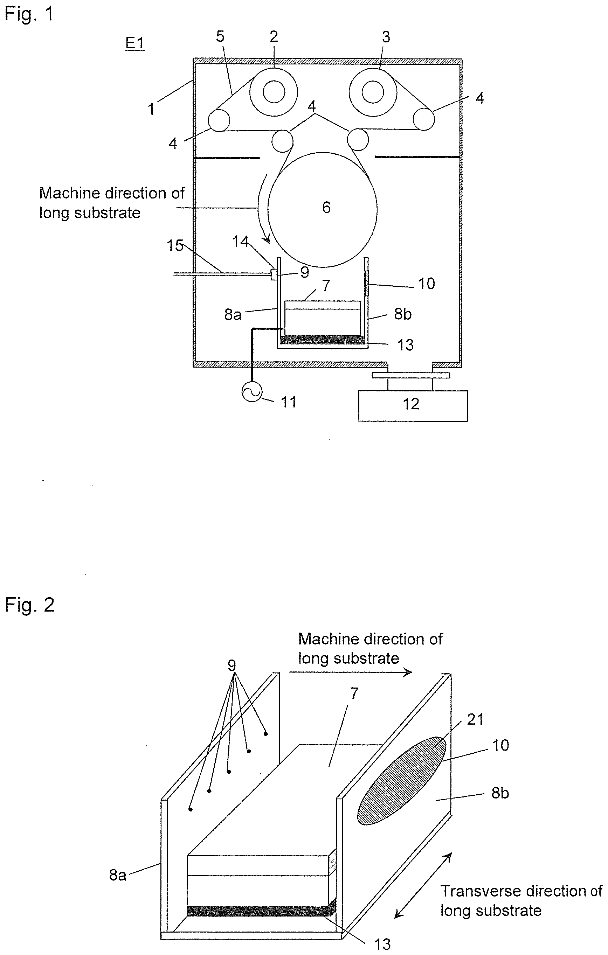

FIG. 1 is a schematic cross sectional view of the plasma CVD apparatus according to an embodiment of the present invention.

In FIG. 1, a plasma CVD apparatus E1 of the present invention has a vacuum chamber 1, and the vacuum chamber 1 is connected to a exhausting apparatus 12. The vacuum chamber 1 accommodates a feed roll 2 and a takeup roll 3, and guide rolls 4 are also provided to convey a long substrate 5 supplied by the feed roll to a main roll 6. The main roll 6 may have a temperature-controlling apparatus such as a cooling mechanism. After the main roll 6, the long substrate 5 is conveyed to other guide rolls 4, and then wound on the takeup roll 3.

A plasma generation electrode 7 may be provided at a position freely selected in consideration of the structure of the vacuum chamber 1 as long as the plasma generation electrode 7 opposes the main roll 6. Size (area) of the surface of the plasma generation electrode 7 opposing the long substrate 5 may be determined by taking width of the long substrate 5 into consideration. When the thin film is formed to opposite edges of the long substrate 5, the plasma generation electrode 7 may have a width (distance in the transverse direction of the long substrate 5) longer than the width of the long substrate 5 in view of the wider film formation area. The plasma generation electrode 7 is insulated from the vacuum chamber 1 by an insulator 13.

The plasma generation electrode 7 is connected to a power supply 11. The power supply 11 used may be any power supply such as radio frequency power supply, pulsed power supply, or DC power supply. Any frequency may be used in the case of the radio frequency power supply, and a radio frequency power supply in VHF band is a radio frequency power supply in view of the ease of generating a high density plasma at a low electron temperature. A pulse modulation or amplitude modulation may be conducted on the output of the radio frequency power supply.

Side walls 8a and 8b are provided on opposite sides of the plasma generation electrode 7 on the upstream side and on the downstream side in the machine direction of the substrate 5. These 2 side walls 8a and 8b are electrically insulated from the plasma generation electrode 7. Such constitution enables localized plasma generation in the space surrounded by the main roll 6, the plasma generation electrode 7, the side walls 8a and 8b, namely, in the film deposition space. Such localized plasma generation is preferable in view of the efficient use of the electricity supplied by the power supply 11 in generating the film deposition species, and hence, in view of the improved film deposition efficiency as well as prevention of unnecessary film deposition on the inner wall of the vacuum chamber 1 and the like. The side walls 8a and 8b are not limited for the material, and use of a metal such as stainless steel or aluminum is preferable in view of the strength and heat resistance as well as the localized plasma generation. In addition, the two side walls 8a and 8b may be connected by a conductor such as a wire so that they are at the same electrical potential. Preferably, the two side walls 8a and 8b are at the ground potential so that the plasma is conveniently confined in the film deposition space. Instead of using the two side walls 8a and 8b at the ground potential, one output terminal may be connected to the plasma generation electrode 7 and the other terminal may be connected to the 2 side walls 8a and 8b when the power supply 11 is the one which can be used at a potential other than the ground potential, and this embodiment is favorable in view of enabling stable discharge for a prolonged period even if the thin film is deposited on the side walls 8a and 8b.

A gas supply hole for supplying the source gas is formed in one of the side wall 8a and side wall 8b, and a gas tube is secured to the side wall provided with the gas supply hole. By limiting the gas supply to one direction, the gas flow will be stable compared to the case of gas introduction from opposite sides. The source gas introduced from the gas supply hole undergoes a reaction into in the film deposition space where the plasma is generated, and a thin film is deposited on the long substrate 5. The gas supply hole has an inner diameter of at least 0.1 mm and up to 3 mm in view of stable discharge conditions by the entering of the plasma to the gas supply hole, and more preferably, an inner diameter of at least 0.5 mm and up to 3 mm additionally in view of working cost and the like.

When there is no side wall present between the side walls on the upstream and downstream in the machine direction of the long substrate 5 and extending in the machine direction of the long substrate 5, the gas not used in the thin film formation will be exhausted from the film deposition space mainly through the gap between the side wall not having the gas supply hole wall (the side wall 8b in FIGS. 1 and 2) and the main roll and through the opening in the machine direction.

FIG. 2 is an enlarged perspective view of the section of the plasma generation electrode 7 and side walls 8a and 8b of the plasma CVD apparatus E1 of FIG. 1.

The side walls 8a and 8b may have a size adequately determined according to the size of the plasma generation electrode 7 and the distance between the plasma generation electrode 7 and the main roll 6. A gap is defined between the side walls 8a and 8b and the side surfaces of the plasma generation electrode 7 (left and right surfaces of the plasma generation electrode 7 in FIGS. 1 and 2). The gap width is preferably 1 to 5 mm in order to suppress abnormal discharge at the gap. While 2 side walls are provided in the embodiment of FIGS. 1 and 2, 2 side walls (at the front and rear side of the plasma generation electrode 7 in FIGS. 1 and 2) extending in the machine direction may be provided to surround the plasma generation electrode 7 like a box. In the actual apparatus, the film deposition space has a longer dimension in the transverse direction of the main roll 6 in most cases, and accordingly, the plasma generation electrode 7 and the side walls 8a and 8b have longer dimensions in the transverse direction of the main roll. Accordingly, the side walls on the upstream side and the downstream side in machine direction of the substrate 5 are more important in confining the plasma. Provision of side walls extending in the machine direction, however, is more preferable in view of more reliability confining the plasma.

In order to prevent inconsistent gas supply, a row of gas supply holes 9 wherein the gas supply holes are aligned in transverse direction of the long substrate 5 may be formed as shown in FIG. 2. In view of the consistent supply of the gas to the space above the plasma generation electrode 7, the gas supply holes are preferably aligned in a row in the transverse direction of the long substrate 5. The arrangement of the gas supply holes is not strictly limited, and the gas supply holes may be aligned diagonally to the transverse direction of the long substrate 5, or microscopically in grid arrangement. However, for introducing different gases from different rows of the gas supply holes, the gas supply holes are preferably aligned in a row in transverse direction of the long substrate also in view of the simple constitution and ease of production. The interval of the gas supply holes is not particularly limited, and according to the findings of the inventors of the present invention, the interval is preferably less than 50 mm in view of avoiding the film deposition inconsistency.

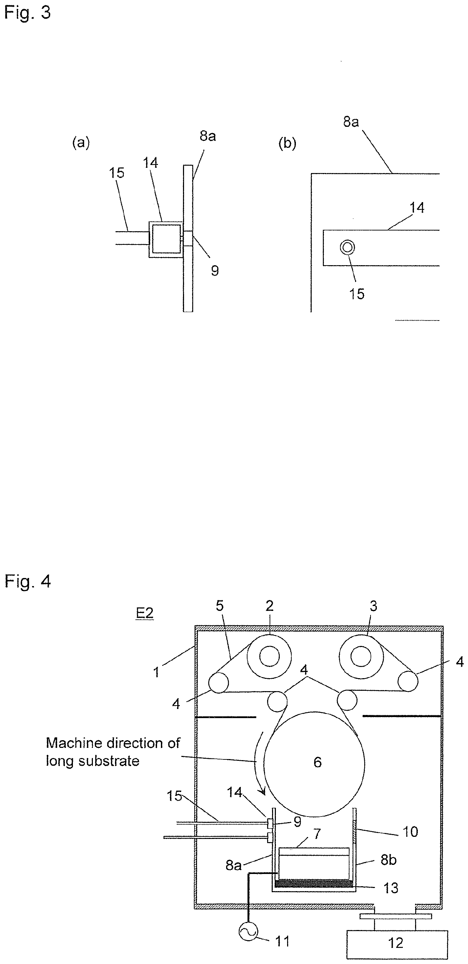

As an embodiment of the gas supply mechanism, FIG. 3(a) is an enlarged cross sectional view of the row of gas supply holes 9 and the surrounding area and FIG. 3(b) is an enlarged rear view of the row of gas supply holes 9 and the surrounding area. The side wall 8a is provided with an arbitrary number of through holes for gas injection at an arbitrary interval. In the side wall 8a, a gas tube 14 is secured to the surface of the side wall 8a at a side opposite to the plasma generation electrode 7. The gas tube 14 has a lumen smaller than the through hole at the position corresponding to the through hole in the side wall 8a. The through hole in the side wall 8a is preferably larger than the lumen of the gas tube 14 in view of facilitating the gas passage from the gas tube 14 to the film deposition area. The source gas is introduced through the gas pipe 15 secured to the gas tube 14, and then uniformly distributed to each of the gas supply holes to enable uniform supply. The gas supply mechanism, however, is not limited to this embodiment.

When the film deposition space is sandwiched between side walls in the upstream and downstream in the machine direction of the long substrate 5 and a side wall extending in the machine direction of the long substrate 5 is provided, the gas is mainly exhausted from the gap between the side wall not provided with the row of gas supply holes 9 (the side wall 8b in FIGS. 1 and 2) and the main roll. When the distance between the main roll 6 and the side wall is reduced, the gas exhaust may become difficult. Accordingly, provision of gas exhaust opening 10 in the side wall opposite to the side wall provided with the row of the gas supply holes facilitates smooth gas exhaust even if the distance between the main roll and the side wall 8b is reduced, and an efficient exhaust of the particles is facilitated.

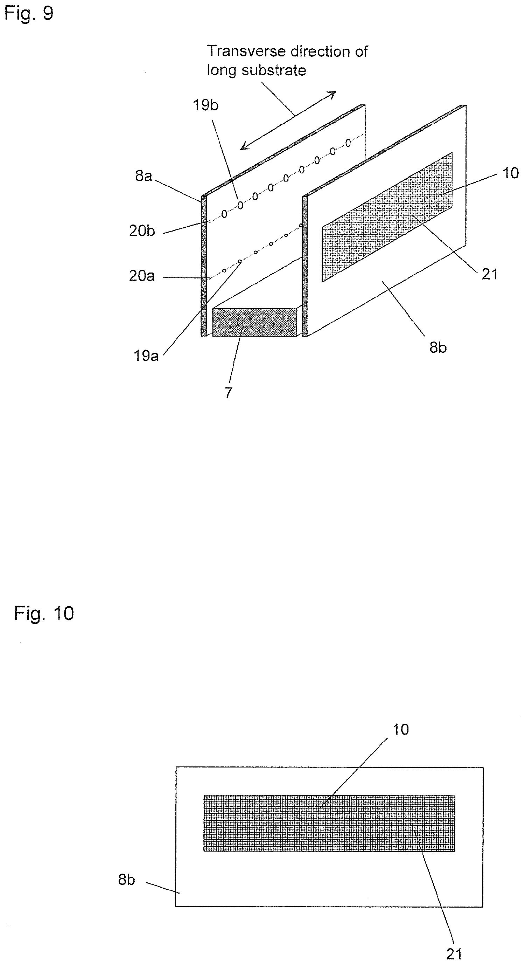

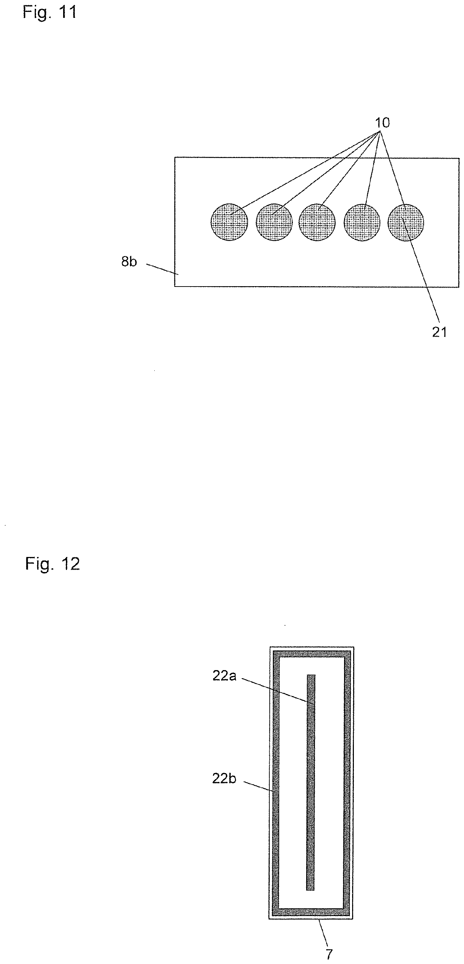

For efficient exhaust of the particles, the gas exhaust opening 10 is provided near the connection port of the exhausting apparatus 12, and if possible, the gas exhaust opening 10 and the connection port of the exhausting apparatus 12 are connected by a duct. The gas exhaust opening 10 is not limited for its shape, size, and number. The gas exhaust opening 10, however, is preferably provided so that uniform gas exhaust is facilitated in the transverse direction of the long substrate 5, and more preferably, so that the gas exhaust opening 10 is open in the area including the projected image of the row of the gas supply holes 9 on the side wall 8b in the direction parallel with the surface of the plasma generation electrode 7. Embodiments of the exhaust opening 10 in the side wall 8b are shown in FIGS. 10 and 11. Non-limiting examples of the exhaust opening 10 include provision of single rectangular opening as shown in FIG. 10, and provision of a plurality of circular openings as shown in FIG. 11.

Since abnormal discharge may occur in the gas exhaust opening 10, the gas exhaust opening 10 is preferably divided into a plurality of gas exhaust holes to the extent not disturbing the gas flow, for the purpose of stabilizing the discharge. This arrangement enables localization and confinement of the plasma within the film deposition space and prevention of the plasma discharge at unnecessary parts of the vacuum chamber 1, and hence, stable plasma generation. This arrangement also enables prevention of the fouling of the interior wall of the vacuum chamber 1, and hence, eases of the maintenance. The formation of such plurality of gas exhaust holes may be most easily realized, for example, by the use of a metal mesh member covering the gas exhaust opening 10, and also, by forming minute holes in the insulator material. When a metal mesh member is used, the metal mesh member may comprise any material such as stainless steel, nickel, or aluminum. The mesh may preferably have a pitch of at least 0.1 mm and up to 3 mm in view of the plasma leakage, and the mesh may preferably have a pitch of at least 0.5 mm and an open area rate of at least 30% in view of the exhaust gas flow.

In the plasma CVD apparatus of the present invention, the pressure in the interior of the vacuum chamber 1 is maintained at a low pressure, and since the film deposition takes place in the area near the molecular flow, and the flow associated with the rotation of the main roll 6 is less likely to occur. Accordingly, the only requirement of the gas introduction is the introduction of gas into the space between the long substrate 5 and the plasma generation electrode 7 in the direction substantially parallel to the long substrate 5. When increase in the film deposition pressure is required, for example, for improving the film deposition speed, the gas is preferably introduced from the upstream side in the machine direction of the long substrate 5, and the gas exhaust opening 10 is preferably provided on the downstream in the machine direction of the long substrate 5 in consideration of the gas glow approaching a viscous flow.

FIG. 4 is a schematic cross sectional view showing the second plasma CVD apparatus E2 according to another embodiment of the present invention.

In the embodiment shown in FIG. 4, two or more rows of the gas supply holes 9 are provided, and the row nearest to the surface of the plasma generation electrode 7 (the upper surface plasma generation electrode in FIG. 4) is capable of supplying a gas which is different from the gas supplied from the other rows of the gas supply holes 9. This arrangement enables separate gas supply to the space nearer to the plasma generation electrode 7 and the space more remote from the plasma generation electrode 7. More specifically, the reactive gas which is more likely to generate particles can be supplied to the space more remote from the plasma to thereby enable control of the gas decomposition in the gas deposition space and the reaction in the formation of the thin film formation. In addition, introduction of the non-reactive gas in the space near the plasma generation electrode 7 results in the reduced fouling or particle deposition of the electrode surface. The term "reactive gas" used herein means the gas which is capable of forming the polymer in the form of, for example, the thin film or the particles by the decomposition of the gas by the plasma and the mutual binding of the resulting active species even if the gas is used alone. Non-limiting examples of such reactive gas include silane, disilane, TEOS (tetraethoxysilane), TMS (tetramethoxysilane), HMDS (hexamethyldisilazane), HMDSO (hexamethyldisiloxane), methane, ethane, ethylene, and acetylene. The term "non-reactive gas" means the gas which is incapable of forming the polymer by the decomposition of the gas by the plasma and the mutual binding of the resulting active species. Non-limiting examples of such non-reactive gas include rare gases such as helium and argon, as well as gases like nitrogen, oxygen, and hydrogen.

In this embodiment, at least two gas tubes 14 are provided for connection with the row nearest to the upper surface of the plasma generation electrode 7 and other rows of gas supply holes 9.

The gas exhaust opening 10 is not limited for its shape, size, number, and the like also in the case of providing two or more rows of the gas supply holes 9 on the side wall 8a, and the exhaust opening 10 is preferably arranged so that the gas is exhausted in a manner uniform in the transverse direction of the long substrate 5. In view of uniform exhaust of the gas, the gas exhaust opening 10 is preferably provided so that the gas exhaust opening 10 is open in the area including the projected image of the open row of gas supply holes 9 on the side wall 8b in the direction parallel to the surface of the plasma generation electrode 7.

Other components of the plasma treatment apparatus E2 are the same or substantively the same as the plasma treatment apparatus E1 of FIG. 1, and therefore, the reference numerals the same as those of FIG. 1 are used in FIG. 4, and the situation is the same for the reference numerals between other drawings.

FIG. 5 is a schematic cross sectional view showing the third plasma CVD apparatus E3 according to further embodiment of the present invention.

In the embodiment of FIG. 5, a magnet 16 for generating a magnetic flux on the surface of the plasma generation electrode 7 (the upper surface of the plasma generation electrode 7 in FIG. 5) is provided in the plasma generation electrode 7. The magnetic field formed on the plasma generation electrode 7 by the magnet is preferably a magnetron magnetic field. FIG. 12 is a horizontal cross sectional view showing the interior of the plasma generation electrode of the present invention. The magnetron magnetic field is the one formed by providing a central magnet 22a and a peripheral magnet 22b in the interior of the plasma generation electrode 7 as shown in FIG. 12, and reversing the polarity of the central magnet 22a and the peripheral magnet 22b so that the shape of the lines of magnetic force representing the magnetic field generated on the surface of the plasma generation electrode 7 is racetrack-shaped tunnel. High density plasma can be generated on the surface of the plasma generation electrode 7 by the confining of the plasma and promotion of electrolytic dissociation by the presence of the magnetron magnetic field, and the generation of the active species contributing for the film deposition is thereby promoted. As a countermeasure for the demagnetization of the magnet 16 which may be caused by the heat generated during the plasma generation, a cooling water pathway 17 is preferably provided in the plasma generation electrode.

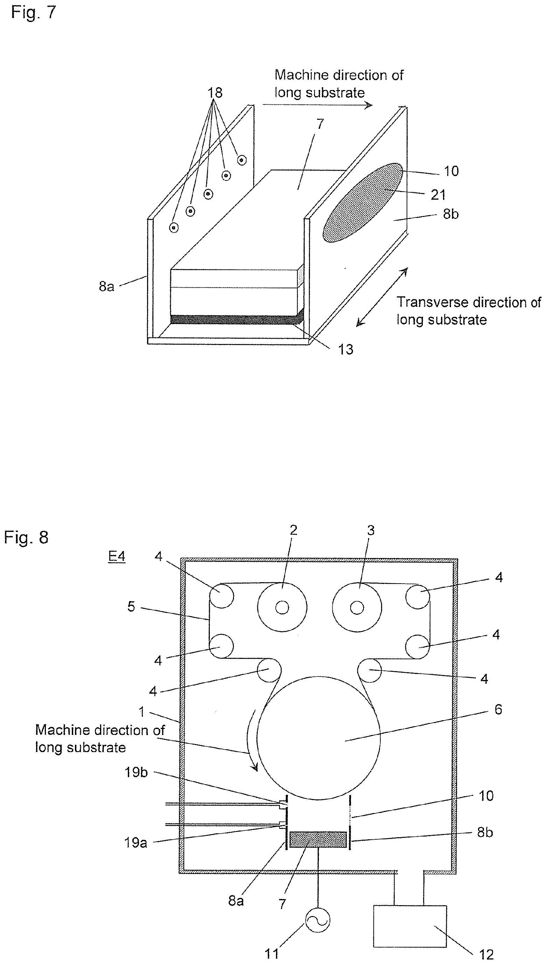

FIG. 7 is an enlarged perspective view of the section of the plasma generation electrode and the side walls 8a and 8b of the plasma CVD apparatus according to the further embodiment of the present invention.

In the embodiment of FIG. 7, the insulated row of the gas supply holes 18 provided in the side wall 8a or the side wall 8b for supplying the source gas is formed from an insulator material such as alumina. The gas supply hole comprising an insulator material may preferably be provided by using a ceramic plate formed with the holes of the desired size for the corresponding part, or alternatively, by thermally spraying a ceramic. Formation of the row of gas supply holes by the insulator material contributes for the prevention of the plasma intrusion into the row of gas supply holes 18.

The plasma CVD apparatus of the present invention effectively minimizes contamination of the thin film by the particles formed during the deposition of the silicon oxide film on the long substrate 5, and hence, loss of the film quality by the contamination of the particles into the thin film to thereby particularly facilitate the formation of the high quality silicon oxide film.

In order to improve productivity of the thin film in the plasma CVD, promotion of the decomposition of the source gas by the plasma for increase in the amount of the active species supplied to the substrate surface is necessary, and method for improving the plasma density has been investigated. Increase in the plasma density has also been considered effective for improving quality of the resulting thin film and adhesion between the film and the underlying substrate, and intensive investigations have been continued also in this aspect.

For example, patent document JP 2005-330553 A discloses a thin film formation wherein plasma is generated between a mesh anode assembled in the reaction tube and a rotatable main roll opposing the reaction tube, and the gas introduced in the reaction tube is decomposed by the plasma to deposit a thin film on the surface of the film substrate having a magnetic layer deposited thereon conveyed by a main roll. Also disclosed is provision of a source of magnetic field on the side opposite to the substrate with regard to the anode, and the magnetic field source is arranged so that a magentic field acts in the direction crossing the direction of the electric field. This I document indicates that decomposition and rebinding of the source gas is promoted by such arrangement of the magnetic field, and improvement in the film quality of the deposited film is enabled by such arrangement.

Patent document JP 2006-131965 A discloses an apparatus wherein a film is formed by plasma CVD method while conveying the substrate. This apparatus comprises an ion source which generates plasma by an inert gas, and a film forming gas introduction mechanism provided on the downstream side of the ion source in the machine direction of the substrate. This apparatus enables simultaneous film deposition and film cleaning treatment by using single ion source, and the document argues that a high quality film exhibiting strong adhesion with the underlying layer can be formed at a high film deposition efficiency for a long time.

Patent document JP 2008-274385 A discloses an apparatus comprising an electrode for ejecting the plasma generated by holocathode discharge, wherein a magnet is provided in the interior of the electrode for producing a magnetic field on the surface of the electrode. Also disclosed is the method wherein oxygen is supplied from the ejection hole, and a silane compound is supplied from the separately provided source ejection section. The Idocument argues that use of such apparatus and method enables compact thin film exhibiting good adhesion while reducing thermal load on the substrate.

However, attempts for increasing the film deposition speed without sacrificing the film quality in response to the demand for improving the productivity have been associated with the following problems.

In the method of patent document JP 2005-330553 A, the gas is introduced from the rear side of the anode, and the gas is introduced without separating the source gas (from which the film formation species are formed) and the plasma forming gas for the purpose of generating the plasma. When the amount of the gas supplied and the electricity applied are increased for the purpose of improving the film deposition speed, amount of the film deposited on the anode and the reaction tube increases and the discharge may become unstable. Also, the plasma generated localizes in the vicinity of the anode where magnetic field is present, and amount of the active species near the anode becomes insufficient and the desired film quality may not be realized.

In the method of patent document JP 2006-131965 A, fouling of the ion source by the film deposition is suppressed since an inert gas is supplied to the ion source. However, when a large amount of active species of the non-polymerizable reactive gas such as oxygen is to be supplied to the vicinity of the substrate, sufficient amount of the active species can not be supplied to the vicinity of the substrate, and the desired film deposition speed can not be realized.

The situation was similar in the method of patent document JP 2008-274385 A. Even if the active species of the non-polymerizable reactive gas such as oxygen is to be supplied to the vicinity of the substrate at a large amount, the active species can not be supplied to the vicinity of the substrate in a sufficient amount since strong plasma could not be produced at a position near the substrate although strong plasma can be formed near the electrode by the holocathode discharge effect and the effect of the magnetic field from the electrode surface, and as a consequence, the desired film deposition speed can not be realized.

Next, the best embodiments of the present invention are described by referring to the drawings. The plasma CVD apparatus and the plasma CVD method for depositing a thin film on the surface of the long substrate by plasma CVD method according to these embodiments, the active species are supplied at a large amount on the surface of the substrate to thereby produce a high quality thin film at a high productivity.

FIG. 8 is a schematic cross sectional view of the fourth plasma CVD apparatus E4 which is a plasma CVD apparatus according to another embodiment of the present invention. The constitution of the apparatus of FIG. 8 is substantially the same as the constitution of the apparatus of FIG. 4 except for the plasma generation-suppressing gas supply holes 19a and the plasma generation-promoting gas supply holes 19b. The plasma generation electrode 7 is functionally the same as the plasma generation electrode 7 of FIGS. 4 and 8 in that electrical discharge is produced by applying electricity to an electroconductive substance.

FIG. 9 is an enlarged perspective view of the plasma generation electrode 7 of the plasma CVD apparatus E4.

In the plasma CVD apparatus E4, the gas supply opening comprises a plasma generation-suppressing gas supply holes 19a which supplies the gas while suppressing the plasma generation and a plasma generation-promoting gas supply holes 19b which supplies the gas while promoting the plasma generation.

The plasma generation-suppressing gas supply hole 19a is a gas supply hole having the function of releasing the gas into the film deposition space without generating the plasma in the gas supply opening. The gas supplied from the plasma generation-suppressing gas supply hole 19a is released into the film deposition space without being subjected to the action of decomposition and excitation by the plasma in the interior of the gas supply hole, and then, released into the film deposition space and subjected for the first time to the decomposition and the excitation by the plasma in the film deposition space.

The plasma generation-promoting gas supply hole 19b is a gas supply hole having the function of releasing the gas into the film deposition space while aggressively generating the plasma in the gas supply hole. The gas supplied from the plasma generation-promoting gas supply holes 19b is released into the film deposition space after being subjected to the action of decomposition and excitation by the plasma in the interior of the gas supply opening, and the gas is further subjected to the decomposition and excitation in the film deposition space

The gas supply opening having such constitution is particularly effective in the case when two or more types of source gases are used. Such gas supply opening is particularly useful when a reactive gas and a non-reactive gas are simultaneously supplied for the film deposition.

In the case of forming a SiO₂ thin film by using TEOS (reactive gas) and oxygen (non-reactive gas) for the source gas, when TEOS (reactive gas) is supplied from the plasma generation-promoting gas supply hole 19b, the species formed by the decomposition polymerizes in the gas supply opening and the resulting polymer deposits in the inner wall of the gas supply opening, and this leads to the unstable supply of the gas supply and clogging of the gas supply opening. In order to prevent such problem, provision of a plasma generation-suppressing gas supply hole 19a for supplying the reactive gas is preferable. On the other hand, oxygen (non-reactive gas) is not likely to clog the gas supply opening as in the case of the reactive gas, and therefore, promotion of the decomposition and excitation of the non-reactive gas is preferable in view of improving the film deposition speed and the film purity. In view of such situation, provision of the plasma generation-promoting gas supply hole 19b for supplying the non-reactive gas is preferable.

The plasma generation-suppressing gas supply hole 19a may be an opening having a small opening so that the plasma doe not enter the gas supply opening, and exemplary such opening include the one having a gas supply opening in the shape of a hole having a sufficiently small opening with sufficiently small inner diameter, and a gas supply opening in the shape of a slit with sufficiently small interval. A gas supply opening having a large opening or a wide interior space with the interior filled with a gas permissible substance such as porous ceramics or steel wool can also be used as a plasma generation-suppressing gas supply opening.

In the present invention, use of a plurality of holes having small inner diameter, namely, a plurality of small-diameter gas supply holes as the plasma generation-suppressing gas supply hole 19a is preferable. Use of an opening in the shape of a hole is easy to work, and the gas can be stably supplied with no deformation of the hole even at an elevated temperature. The small-diameter gas supply holes may preferably have an inner diameter of at least 0.1 mm and up to 3 mm. When the plasma generation-suppressing gas supply opening is in the shape of a hole, the inner diameter of the small-diameter gas supply hole is preferably at least 0.1 mm in view of reducing the cost of drilling a , and the risk of clogging of the gas supply hole by a foreign matter can be reduced. Accordingly, the diameter is preferably at least 0.1 mm, and more preferably at least 0.5 mm. When the inner diameter is up to 3 mm, the risk of the plasma entering the gas supply opening will be reduced, and the plasma generation will be sufficiently reduced.

The plasma generation-promoting gas supply hole 19b may be an opening having a large opening so that the plasma enters the gas supply opening, and exemplary such opening include the one having a gas supply opening in the shape of a hole having a sufficiently large inner diameter, and a gas supply opening in the shape of a slit with sufficiently large interval between the slits.

In the present invention, use of a plurality of holes with a large inner diameter, namely, a large-diameter holes for the plasma generation-promoting gas supply hole 19b is preferable in view of the ease of working. The large-diameter gas supply hole may preferably have an inner diameter of at least 4 mm and up to 15 mm since the inner diameter of such range results in the increased density of the plasma that has entered the gas supply hole due to the hollow discharge effect, thereby promoting the dissociation and excitement of the gas. According to the finding of the inventors of the present invention, entering of the plasma in the gas supply hole is promoted when the large-diameter gas supply hole has an inner diameter of at least 4 mm, and when the inner diameter is up to 15 mm, hollow discharge effect in the gas supply hole is likely to be high, and the plasma density in the gas supply hole will be sufficiently high and the plasma generation will be promoted.

The plasma generation-suppressing gas supply holes 19a and the plasma generation-promoting gas supply holes 19b in the side wall 8a are preferably arranged so that the gas supply holes are aligned in transverse direction of the long substrate 5 in view of the ease of realizing the uniformity of the gas supply conditions in the transverse direction of the long substrate 5. The plasma generation-suppressing gas supply hole 19a preferably forms at least one the plasma generation-suppressing gas supply opening 20a each aligned in transverse direction of the long substrate 5.

The plasma generation-promoting gas supply hole 19b may also preferably form at least one row of the plasma generation-promoting gas supply hole 20b aligned in the transverse direction of the long substrate 5.

The gas supply opening nearest to the main roll 6 is preferably a plasma generation-promoting gas supply hole 19b. In general, when electricity is applied to the plasma generation electrode 7 to generate plasma in the film deposition space, a high density plasma is often formed near the plasma generation electrode 7. On the hand, density of the plasma near the long substrate 5 is not so high. When the plasma generation electrode 7 and the long substrate 5 are remote, difference in the density between the area near the plasma generation electrode 7 and the area near the long substrate 5 is significant. When the density near the long substrate 5 should be high, the gas supply opening nearest to the main roll 6 should be the plasma generation-promoting gas supply hole 19b to realize distribution of the high density plasma near the long substrate

As a countermeasure for the fouling of the plasma generation electrode 7, the gas supply opening nearest to the plasma generation electrode 7 may be the plasma generation-promoting gas supply hole 19b. In the case of such constitution, when the non-polymerizable gas is supplied from the plasma generation-promoting gas supply hole 19b, the plasma near the plasma generation electrode 7 will be at a higher density by the plasma generated in the gas supply opening, and also, fouling of the electrode 7 can be reduced by the flow of the non-polymerizable gas from the plasma generation-promoting gas supply hole 19b.

In the plasma CVD apparatus E4, the gas exhaust opening 10 is preferably provided in the side wall 8b of the two side walls, namely in the side wall 8b which is opposite to the side wall 8a having the plasma generation-suppressing gas supply hole 19a and the plasma generation-promoting gas supply hole 19b.

In addition, when the magnet in the interior of the plasma generation electrode 7 and the plasma generation-promoting gas supply hole 19b in the side wall 8a are simultaneously used, high density plasma is generated not only on the surface of the plasma generation electrode 7 but also in the interior of the plasma generation-promoting gas supply hole 19b in the side wall 8a. This constitution is preferable since generation of the active species contributing for the film deposition will be synergistically promoted.

When a plasma CVD apparatus like E4 is used, a high quality thin film can be stably formed for prolonged period with a high productivity.

Next, an embodiment of the method for producing a silicon oxide film is described as an example of the CVD method.

The method for producing a silicon oxide film according to the first embodiment is the production method the production method using the plasma CVD apparatus E1 shown in FIG. 1 and the plasma CVD apparatus wherein the row of the insulated gas supply holes 18 shown in FIG. 7 is used in the plasma CVD apparatus E1. As an example, the case using the plasma CVD apparatus E1 of FIG. 1 is described.

A silicon oxide film is formed on the long substrate 5 by using the plasma CVD apparatus E1. The long substrate 5 is set on the feed roll 2 of the plasma CVD apparatus E1, and the long substrate 5 is conveyed to the takeup roll 3 via the guide rolls 4 and the main roll 6. The interior of the vacuum chamber 1 is sufficiently evacuated by the exhausting apparatus 12, and then, the silicon-containing source gas and oxygen are introduced into the gas tube 14 from the gas pipe 15, and the gas is then supplied in the plasma formation space through the row of the gas supply holes 9. The interior of the vacuum chamber 1 is adjusted to the pressure desirable for conducting the plasma CVD. Electricity is supplied from the power supply 11 to the plasma generation electrode 7, and plasma is generated between the plasma generation electrode 7 and the main roll 6 for the gas decomposition. Plasma with little abnormal discharge can be formed since projection like gas supply nozzle is absent in the area around the film deposition space. The gas used is exhausted to the exterior of the film deposition space through the gas exhaust opening 10. The long substrate 5 is conveyed from the feed roll 2 to the takeup roll 3, and the silicon oxide film is formed on the long substrate 5. In this process, the exhaust opening 10 is preferably covered with a metal mesh member or the like since the plasma can be confined in the area near the plasma generation electrode 7 without intervening the gas exhaust.

In depositing a silicon oxide film, a reactive gas containing Si atom or C atom in the molecule is used for the source gas. Non-limiting examples of such gas include silane, disilane, TEOS (tetraethoxysilane), TMS (tetramethoxyilane), HMDS (hexamethyldisilazane), HMDSO (hexamethyldisiloxane), methane, ethane, ethylene, and acetylene. The source gas may be diluted not only by the oxygen but also by other rare gases such as argon.

The silicon oxide film formed on the long substrate 5 is a high quality uniform film with reduced contamination by the particles.

The second embodiment of the silicon oxide film formation is a production method using the plasma CVD apparatus E2 or E3 of FIGS. 4 and 5. As an example, the method using the plasma CVD apparatus E2 of FIG. 4 is described.

A silicon oxide film is formed on the long substrate 5 by using the plasma CVD apparatus E2. The long substrate 5 is set on the feed roll 2 of the plasma CVD apparatus E2, and the long substrate 5 is conveyed to the takeup roll 3 past the guide rolls 4 and the main roll 6. The interior of the vacuum chamber 1 is sufficiently evacuated by the exhausting apparatus 12. Preferably, at least two rows of the gas supply holes 9 are provided, and the row of the gas supply holes 9 nearest to the surface of the plasma generation electrode 7 is supplied with a gas different from the gas supplied to other rows of the gas supply holes in view of further reducing the deposition of the particles on the electrode. The interior of the vacuum chamber 1 is adjusted to the pressure desirable for conducting the plasma CVD. Electricity is supplied from the power supply 11 to the plasma generation electrode 7, and plasma is generated between the plasma generation electrode 7 and the main roll 6 for the gas decomposition. The gas used is exhausted to the exterior of the film deposition space through the gas exhaust opening 10. The long substrate 5 is conveyed from the feed roll 2 to the takeup roll 3, and the silicon oxide film is formed on the long substrate 5. In this process, the exhaust opening 10 is preferably covered with a metal mesh member or the like since the plasma can be confined in the area near the plasma generation electrode 7 without intervening the gas exhaust.

Preferably, a polymerizable gas containing Si atom or C atom in the molecule is supplied from the row of the gas supply holes 9 remote from the plasma generation electrode 7, while a non-polymerizable gas such as argon or helium is supplied from the row of the gas supply holes 9 nearest to the plasma generation electrode 7 to thereby further reduce the deposition of the particles on the electrode. Non-limiting examples of the polymerizable gas containing the Si atom or the C atom in the molecule include silane, disilane, TEOS (tetraethoxysilane), TMS (tetramethoxsilane), HMDS (hexamethyldisilazane), HMDSO (hexamethyldisiloxane), methane, ethane, ethylene, acetylene.

The film deposition as described above has enabled reduced deposition of the particles near the electrode, resulting in stable film deposition as well as reduced film contamination by the particles.

The method for producing a silicon oxide film according to the third embodiment is the production method using the plasma CVD apparatus E4 shown in FIGS. 8 and 9.

In the plasma CVD of the present invention, the gas is supplied to the evacuated space from a plurality of gas supply holes, and the plasma is generated by the plasma generation electrode 7 to form a thin film on the long substrate 5 conveyed on the surface of the main roll 6. Two side walls each extending in the transverse direction of the long substrate 5 are provided in the upstream and the downstream in the machine direction of the long substrate 5 of the film deposition space sandwiched by the main roll 6 and the plasma generation electrode 7. A generation-suppressing gas supply hole 19a which supplies the gas while suppressing the plasma generation and a plasma generation-promoting gas supply hole 19b which supplies the gas while promoting the plasma generation are preferably provided on side wall 8a which is at least one of the two side walls. Preferably, the plasma generation-promoting gas supply hole 19b supplies the non-polymerizable gas with the plasma entering in the interior of the gas supply hole, while the plasma generation-suppressing gas supply hole 19a supplies a gas at least containing the polymerizable gas containing Si atom or C atom in the molecule with the plasma not entering in the interior of the gas supply hole. The gas supply as described above is preferable since the non-polymerizable gas which has been highly activated by the plasma in the interior of the gas supply opening can be supplied to the surface of the long substrate 5, and this enables improvement in the film deposition speed and the film quality. In addition, the polymerizable gas is free from the problem of the clogging of the gas supply opening by the polymerization of the polymerizable gas in the gas supply opening since the plasma does not enter the gas supply holes.

Next, the examples for a reactive sputtering apparatus are described.

Various vacuum thin film deposition methods are used in addition to the CVD, and exemplary such methods include, for example, vapor deposition and sputtering method. A suitable method is selected depending on the balance between the properties required for the film and productivity. Sputtering is generally used for the film deposition of an alloy material or in the case when uniform film deposition in large area is required. Compared with other film deposition methods, sputtering has disadvantage of difficulty in increasing the film deposition speed and low productivity. Increase in the film deposition speed has been attempted, for example, by establishing the high density plasma technique such as magnetron sputtering method.

As compactly explained in Ikuro Sugai et al. "Plasma Electronics" (Ohm Publishing, August, 2000, pp.99 to 101), the mechanism of "magnetron discharge" is trapping of electrons by the loop of magnetic flux to increase the plasma density. The magnetron sputtering method developed by using this magnetron sputtering method to the sputtering electrode has enabled increase in the film deposition speed since the high density plasma promotes sputtering to the target.

The reactive sputtering method is a technique wherein the target atom ejected by sputtering is reacted with a gas such as oxygen or nitrogen, and resulting substance is deposited on the substrate as a thin film. Use of the reactive sputtering method enables deposition of not only metal materials but also oxide and nitride. However, the reactive sputtering of an insulator substance such as deposition of copper nitride from a copper target and nitrogen suffered from the problem of deposition of the insulator substance on the target surface with lapse of time, and the deposition of the insulator substance on the target surface resulted in the change of the electric field on the target surface, and this resulted in the problems such as loss of film uniformity and generation of arc discharge.

In view of such situation, patent document JP 2009-199813 A discloses an apparatus for depositing a transparent electroconductive film. This apparatus comprises a reactive sputtering apparatus has a sputtering electrode having a cathode electrode and a radio frequency-applying section, and argon gas is supplied to the vicinity of the cathode electrode surface, namely, to the vicinity of the target surface, and a reactive gas is supplied to the radio frequency-applying section. Since the argon gas is supplied to the vicinity of the target, and a reactive gas is separately supplied to the vicinity of the substrate in this apparatus, the reactive sputtering can be conducted without changing the surface conditions of the target. In addition, since inductively coupled plasma can be generated between the target and the substrate during the sputtering by the radio frequency, reaction between the target atom and the reactive gas can be improved, and stable formation of the high quality transparent electroconductive film is enabled.

However, the document as described above is silent about the fouling of the radio frequency-applying section which is exposed to the plasma as in the case of the cathode electrode. According to the finding of the inventors of the present invention, the metal particles sputtered from the target reacts with the reactive gas in the vicinity of the radio frequency-applying section, and conceivably, the film is deposited not only on the substrate but also on the radio frequency-applying section. Accordingly, plasma stability is lost in the long-term discharge, and in such case, stable film deposition may be no longer possible. In addition, according to the findings of the inventors of the present invention, when the radio frequency-applying section is removed from the apparatus as described above, reaction between the sputtered metal particles and the reactive gas is not promoted and the film deposition speed would be reduced. In addition, the methods used for the supplying and exhausting of the gas are ambiguous.

With regard to the reactive sputtering apparatus capable of forming a film on a long substrate, examples describe a reactive sputtering apparatus and the method wherein fouling of the target surface is suppressed and the uniformity of the film deposition speed and film quality is retained for a long time. These examples are described by referring to the drawings.

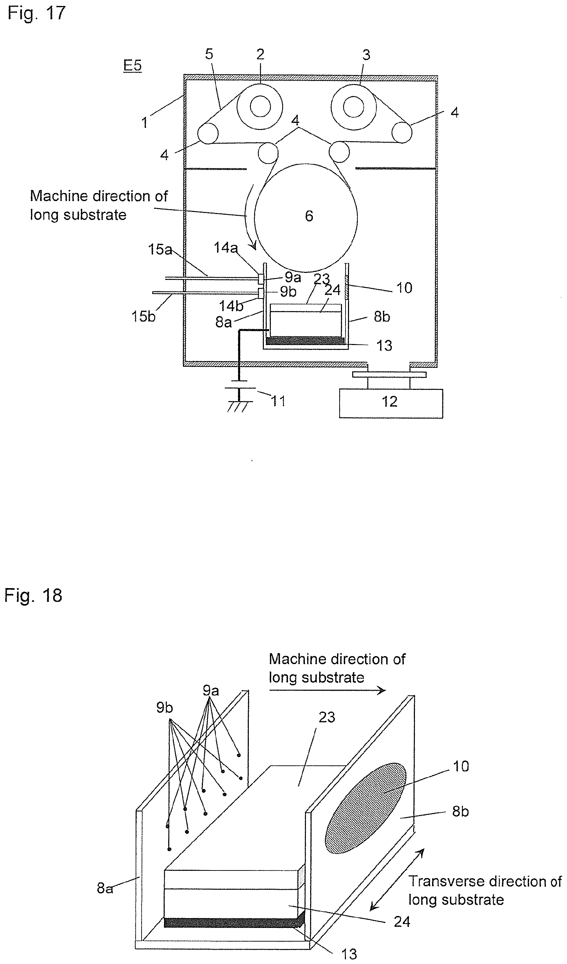

FIG. 17 is a schematic cross sectional view of the reactive sputtering apparatus according to an example.

The reactive sputtering apparatus E4 of the present disclosure shown in FIG. 17 has a vacuum chamber 1. The vacuum chamber 1 is connected to the exhausting apparatus 12, and the the vacuum chamber 1 accommodates the feed roll 2 and the takeup roll 3. The guide rolls 4 are also provided to convey the long substrate 5 from the feed roll 2 to the main roll 6. The main roll 6 may be provided with a temperature adjusting mechanism such as cooling mechanism. The long substrate 5 which has passed the main roll 6 is conveyed past the guide rolls 4 to the takeup roll 3 where the long substrate 5 is wound.

A magnetron electrode 24 connected to the power supply 11 is provided at the position opposing the main roll 6, and the magnetron electrode 24 supports the target 23. The target 23 is not limited for its material, and any material may be selected depending on the type of the material to be deposited, and copper may be selected when a copper nitride film is to be deposited. One side wall 8a and one side wall 8b are provided on the upstream side and the downstream side in the machine direction of the long substrate 5 to sandwich the magnetron electrode 8. One of the side walls in the upstream side or in the downstream side (the side wall 8a in the drawing) is provided with the row of the gas supply holes 9a and 9b for supplying the source gas, and the other side wall (side wall 8b in the drawings) is provided with the gas exhaust opening 10 for the exhaust of the gas.

Position of the magnetron electrode 24 may be freely selected by considering the structure of the interior of the vacuum chamber 1 as long as the main roll 6 and the magnetron electrode 24 oppose each other. The size (area) of the surface of the magnetron electrode 24 opposing the long substrate 5 may be adequately selected by taking the size of the long substrate 5 into consideration. However, the surface of the magnetron electrode 24 may have a width in the transverse direction of the long substrate 5 larger than the width of the long substrate 5 when the film is to be deposited to the opposite end of the long substrate 5 in transverse direction (i.e. to the opposite edges in the machine direction). The size of the target 23 supported by the magnetron electrode 24 may be selected by the same concept.

The magnetron electrode 24 is provided in its interior with a magnetic field generating means, for example, a magnetic circuit by magnets for magnetron. Use of the magnetic field enables formation of high density plasma on the surface of the target 23. As a countermeasure for the demagnetization of the interior magnet which may be caused by the heat generated during the plasma generation, a cooling water pathway is preferably provided in the plasma generation electrode.

The power supply 11 used may be, for example, a DC power supply, DC pulsed power supply, or RF power supply, and in the case of depositing a film of an insulator material such as copper nitride, the preferred is the use of DC pulsed power supply in view of realizing stable discharge and high film deposition speed.

FIG. 18 is an enlarged perspective view of the magnetron electrode 24 and the side walls 8a and 8b section of the reactive sputtering apparatus E1 of FIG. 17.

Size of the side walls 8a and 8b is selected depending on the size of the magnetron electrode 24 and the distance between the magnetron electrode 24 and the main roll 6. The side walls 8a and 8b are provided at a gap with the side surface of the magnetron electrode 24 (left and right surfaces of the magnetron electrode 24 in FIG. 18), and the side walls 8a and 8b are insulated from the magnetron electrode 24. The width of the gap is preferably 1 to 5 mm in view of suppressing the abnormal discharge in the gap. If desired, an insulator material may be provided between the magnetron electrode 24 and the side walls 8a and 8b. In view of stabilizing the discharge, each of the side walls 8a and 8b is preferably grounded. By such arrangement, localized plasma generation in the space surrounded by the main roll 6, the plasma generation electrode 24, and the side walls 8a and 8b, namely, the film deposition space is realized in addition to the effect of the magnetic circuit in the magnetron electrode 24. Such arrangement is also preferable in view of preventing unnecessary film deposition on the inner wall of the vacuum chamber 1. Electrical potential of the 2 side walls 8a and 8b may be equilibrated, for example, by connecting with a conductor such as a lead. Besides the equilibration to the ground potential of the 2 side walls 8a and 8b, it is also preferable that one terminal is connected to the plasma generation electrode 24 and the other terminal is connected to the 2 side walls 8a and 8b by using a power supply 11 which can be used at a potential other than the ground potential since the discharge can be continued stably for a prolonged period even if the thin film were deposited on the side walls 8a and 8b. In the absence of the side walls 8a and 8b, plasma will spread to the main roll 6 and the vacuum chamber 1, and the plasma is likely to become unstable. FIG. 18 shows the case wherein one side wall 8a and one side wall 8b are respectively provided in the upstream side and the downstream side in the machine direction of the long substrate 5, and side walls may also be provided at the front and the rear sides at opposite ends in transverse direction of the long substrate 5 to cover all sides of the magnetron electrode 24 in box shape. In practical point of view, the film deposition space is often longer in the transverse direction of the main roll 6, and hence, the plasma generation electrode 24, and the side walls 8a and 8b are longer in the transverse direction of the main roll, and the side walls of significance in view of surrounding the plasma are those in the upstream side and the downstream side in the machine direction of the long substrate 5. However, for more reliable localization of the plasma, provision of the front and rear side walls on the opposite ends in transverse direction of the long substrate 5 is preferable.

In order to prevent inconsistent gas supply, the rows of the gas supply holes 9a and 9b provided in the side wall 8a are preferably formed from a plurality of gas supply holes aligned in the transverse direction of the long substrate 5 as shown in FIG. 18 in view of preventing the inconsistency in the gas supply. The arrangement of the gas supply holes is not strictly limited, and the gas supply holes may be aligned diagonally to the transverse direction of the long substrate 5, or microscopically in grid arrangement as long as the gas is uniformly supplied to the film deposition space. However, for introducing different gases from different rows of the gas supply holes 9a and 9b, the gas supply holes are preferably aligned in a row in transverse direction of the long substrate also in view of the simple construction of the apparatus. The interval of the gas supply holes is not particularly limited, and according to the findings of the inventors of the present invention, the interval is preferably up to 50 mm in view of avoiding the film deposition inconsistency.

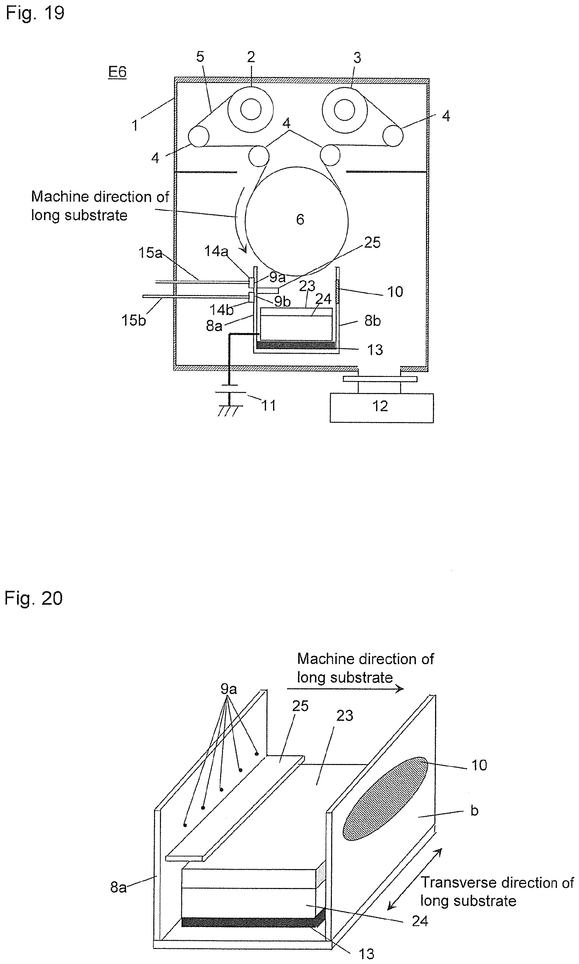

Of the rows of the gas supply holes 9a and 9b, the one nearest to the surface of the target 23 (the row of the gas supply holes 9b in FIGS. 18 and 19) supplies the non-reactive gas, and other rows of gas supply holes (the row of the gas supply holes 9a in FIGS. 18 and 19) supplies the reactive gas. The non-reactive gas may be any gas selected from those not chemically reacting with the material of the target 23 such as argon. The reactive gas is not particularly limited, and may be freely selected, and the reactive gas is, for example, nitrogen when the copper nitride film is to be deposited. A high density plasma apace is formed near the surface of the target 23 by the magnetron discharge. The row of gas supply holes 9b nearest to the surface of the target 23 is preferably provided so that the non-reactive gas is supplied to the area of high density plasma. More specifically, in order to supply the non-reactive gas to the vicinity of the surface of the target 23, the position of the gas supply holes included in the row of the gas supply holes 9b in the side wall 8a is determined as described below. When parallel flux density (flux density in the direction parallel to the target surface) is measured in vertical direction from the position where the parallel flux density is maximum on the surface of the target 23 to the main roll 6, and the point where the parallel flux density is 50% of the maximum value of the parallel flux density in the surface of the target 23 is determined, and the plane including this point is used as a standard plane, the row of the gas supply holes 9b is preferably provided in the area on the side of the target 23 of the standard plane. The parallel flux density may be measured, for example, by using gaussmeter TM-201 manufactured by KANETSU, bringing the sensor section of the probe tip in direct contact with the surface of the target 23, identifying the position of the maximum flux density on the surface of the target 23, moving the prove from that position of the main roll, and measuring the parallel flux density,

On the other hand, the row of gas supply holes 9a is preferably provided so that the reactive gas is supplied to the area on the side of the main roll 6 of the high density plasma area. More specifically, the row of the gas supply holes 9a preferably provided in the area on the side of the main roll 6 of the standard plane as described above. When the gas is supplied as described above, the film deposition speed can be improved by the magnetron discharge, and deposition of the film forming species formed by the reaction between the target particles and the reactive gas on the surface of the target 23 can be suppressed, thereby enabling stable sputtering for a long period.

FIG. 3(a) is an enlarged side elevational view of the gas supply section of the reactive sputtering apparatus according to an example, and FIG. 3(b) is an enlarged rear elevational view of the gas supply section of the reactive sputtering apparatus according to an example. The side wall 8a is provided with through holes for gas injection, and any desired number of through holes may be provided at any desired interval. Gas tubes 14a and 14b are secured to the side wall 8a on the surface opposite to the magnetron electrode 24. The gas tubes 14a and 14b is provided with a lumen for introduction of the gas at a position corresponding to the through holes formed in the side wall 8a. The lumen in the gas tubes 14a and 14b is preferably smaller than the through hole in the side wall 8a to thereby facilitate smooth flow of the gas from the gas tubes 14a and 14b to the gas deposition space. The source gas introduced from the gas tubes 15a and 15b respectively connected to the gas tubes 14a and 14b is distributed and supplied to each of the gas supply holes. The gas supply hole has an inner diameter of at least 0.1 mm and up to 3 mm in view of the stability of the discharge conditions by the entrance of the plasma into the gas supply hole, and at least 0.5 mm and up to 3 mm additionally in consideration of the working cost.

In the reactive sputtering apparatus according to an example, the pressure in the interior of the vacuum chamber 1 is maintained at a low pressure, and since the film deposition takes place in the area near the molecular flow, the flow associated with the rotation of the main roll 6 is less likely to occur. Accordingly, the only requirement of the gas supply is supply of the gas into the space between the long substrate 5, the target 23, and the magnetron electrode 24 in the direction substantially parallel to the long substrate 5. When the gas flow resembles a viscous flow in particular film deposition conditions, the gas is preferably introduced from the upstream side in the machine direction of the long substrate 5.

The side wall 8b opposing the side wall 8a is provided with the gas exhaust opening 10. For efficient exhaust of the gas, the gas exhaust opening 10 is provided near the connection port of the exhausting apparatus 12, and if possible, the gas exhaust opening 10 and the connection port of the gas exhaust apparatus 12 are connected by a duct. Preferably, the gas exhaust opening 10 is also provided so that the gas exhaust opening 10 is open to include the projected image of the row of the gas supply holes 9 on the side wall 8b in the direction parallel with the surface of the plasma generation electrode 7. The gas exhaust opening 10 is preferably open in the area including the projected image of the row of the gas supply holes 9 on the side wall 8b in the direction parallel with the surface of the plasma generation electrode 7.

When there is no side wall between the side walls 8a and 8b on the upstream and downstream in the machine direction of the long substrate 5 at the front and rear sides in the transverse direction of the long substrate 5, the gas that was not used in the thin film formation will be exhausted from the film deposition space mainly through the gas exhaust opening 10 and through the opening in the machine direction. When there are side walls sandwiched by the side walls on the upstream and downstream in the machine direction of the long substrate 5 at the front and rear sides in the transverse direction of the long substrate 5, the gas will be exhausted through gas exhaust opening 10.

FIG. 19 is a schematic cross sectional view of the reactive sputtering apparatus E5 according to another example.

In the example of FIG. 19, a gas distributing plate 25 extending in the transverse direction of the long substrate 5 is provided between the row of gas supply holes nearest to the surface of the target 23 supported by the magnetron electrode 24 and the row of gas supply holes second nearest to the surface of the target 23 of the 2 or more rows of the gas supply holes. When the gas distributing plate 25 is provided, the gas will be guided in the direction substantially parallel to the surface of the target 23 even if the direction of the non-reactive gas ejected is not the direction of the surface of the target 23.

FIG. 20 is an enlarged perspective view of the section of the magnetron electrode 24 and the side walls 8a and 8b of the reactive sputtering apparatus E5 of FIG. 19. The gas distributing plate 25 extends to in some length in the direction of the gas injection from the side wall 8a. The gas introduced from the row of the gas supply holes 9a and 9b spreads into the film deposition space maintained at a low pressure. Provision of the gas distributing plate 25 suppresses mixing of the non-reactive gas exiting the row of the gas supply holes 9a on the side of the target 7 of the gas distributing plate 25 with the reactive gas exiting the row of the gas supply holes 9b on the side of the main roll 6 film deposition space, and flow of the non-reactive gas along the surface of the target 23 is facilitated.

According to the findings of the inventors of the present invention, the length of the gas distributing plate 25 in the machine direction of the long substrate 5 is at least 15 mm and less than 25% of the width of the electrode in the machine direction of the long substrate 5 in view of the effect of suppressing the gas flow and stability of the discharge. More preferably, the gas distributing plate 25 does not extend into the area where plasma is concentrated by the magnetic circuit.

Other components of the reactive sputtering apparatus E5 of FIG. 19 are the same as the reactive sputtering apparatus E4 of FIG. 17, and therefore, the reference numerals the same as those of FIG. 17 are used in FIG. 19, and the situation is the same for the reference numerals between other drawings.

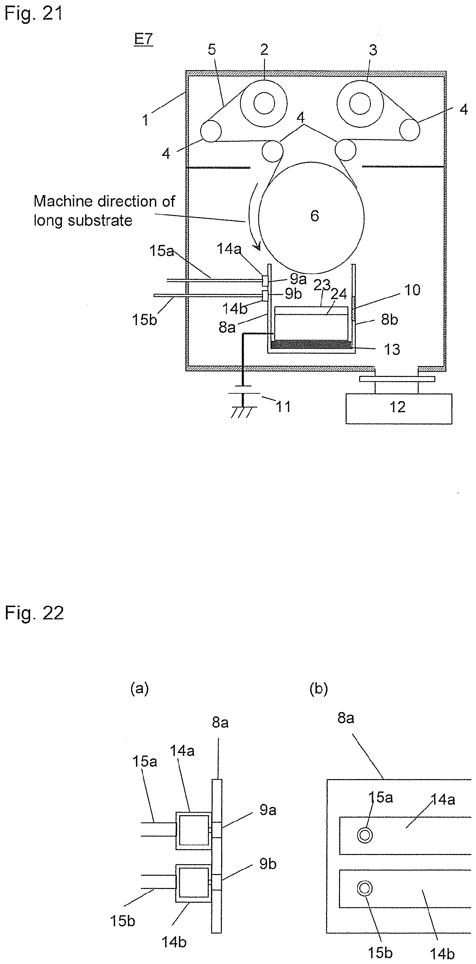

FIG. 21 is a schematic cross sectional view of the third reactive sputtering apparatus E6 according to a further example.

In the example of FIG. 21, intermediate position of the row of the gas supply holes nearest to the surface of the target 23 and the row of the gas supply holes second nearest to the surface of the target 23 of the plurality of rows of the gas supply holes formed in the side wall 8a is on the vertically upper side (on the side nearer to the main roll 6) of the central position in the area of the gas exhaust opening 10. By arranging the gas exhaust opening 10 at such position, flow of the non-reactive gas along the vicinity of the surface of the target 23 is facilitated, and this results in the suppressed fouling of the surface of the target 23 and stable discharge.

The central position in the area of the gas exhaust opening 10 is the center of the gravity of the shape of the gas exhaust opening 10. For example, point of intersection of two diagonals in the case of a rectangle, and center of the circle in the case of a circle are the central position in the area. When the shape of the gas exhaust opening is a triangle, the intersection point of two lines (medians) each between the apex and the central point of the side opposing the apex for 2 apexes of the 3 apexes of the triangle is the gravity center of the triangle, namely, the central position of in the area of the gas exhaust opening. In the case of quadrilaterals having unequal diagonals, which are not the quadrilaterals such as square and rectangle, the gravity center is calculated by the following procedure. A quadrilateral can be divided into two triangles in two ways by using each of the two diagonals. The gravity center is determined for each of the 2 triangles, and a line (centroidal line) can be drawn between these two gravity centers. The gravity center of the quadrilateral can be determined by finding the point of intersection of the centroidal line determined for the first diagonal and the centroidal line determined for the second diagonal. In the case of the pentagon, the gravity center can be determined by dividing the pentagon into a triangle and a quadrilateral in two ways. In the case of other polygons having more than 5 sides, the gravity center can be determined by figuring out the way of division. The gas exhaust opening 11, however, may preferably have an oval, rectangular, or other similar shape since the shape with left-right asymmetry will result in the inconsistent gas exhaust.

Since abnormal discharge may occur in the gas exhaust opening 10, the gas exhaust opening 10 preferably has a plurality of gas exhaust holes to the extent not disturbing the gas flow, for the purpose of stabilizing the discharge. This arrangement enables localization of the plasma in the film deposition space prevention of the plasma discharge at unnecessary part of the vacuum chamber 1, and hence, stable plasma generation. This arrangement also enables prevention of the fouling of the interior wall of the vacuum chamber 1, and hence, ease of the maintenance. The formation of such plurality of gas exhaust holes may be most easily realized, for example, by the use of a metal mesh covering the gas exhaust opening 10, and also, by forming minute holes in the insulator material. When a metal mesh is used, the metal mesh may comprise any material such as stainless steel, nickel, or aluminum. The mesh may preferably have a pitch of at least 0.5 mm and up to 2 mm and an open area rate of at least 30% in view of the plasma leakage and the exhaust gas flow.

Next, a method for producing a copper nitride film is described as an example of the reactive sputtering method.

Examples of the method for depositing a copper nitride film include production methods using the reactive sputtering apparatus E4, E5, and E6 shown in FIGS. 17, 19, and 21. The example using the reactive sputtering apparatus E4 of FIG. 17 is described.

The long substrate 5 is set on the feed roll 2 in the vacuum chamber 1, and the long substrate 5 is conveyed via the guide rolls 4 and the main roll 6 to the takeup roll 3, and the vacuum chamber 1 is evacuated by the exhausting apparatus 12. Argon is then introduced as the non-reactive gas from the gas pipe 15b to the gas tube 14b, and nitrogen as the reactive gas is introduced from the gas pipe 15a to the gas tube 14a. The reactive gas is supplied to the film deposition space from the row of the gas supply holes 9b, and the non-reactive gas is supplied to the film deposition space from the row of the gas supply holes 9a. The interior of the vacuum chamber 1 is adjusted to the pressure adapted for the reactive sputtering. Electricity is supplied from the power supply 11 to the magnetron electrode 24 to thereby form plasma between the target 23 and the magnetron electrode 24, and the main roll 6. A high density plasma is formed on the surface of the target 23 of a metal supported by the magnetron electrode 24 by the magnetic circuit in the interior of the magnetron electrode 24. The particles released to the film deposition space from the target 23 by the sputtering reacts with the reactive gas to form the film deposition species. The gas used is exhausted to the exterior of the film deposition space from the gas exhaust opening 10. The long substrate 5 is conveyed from the feed roll 2 to the takeup roll 3 to thereby deposit the film formation species on the surface of the long substrate 5.

In the reactive sputtering method of the example, the non-reactive gas selected is preferably a rare gas which does not undergo a chemical reaction with the material of the target 23, and in view of the production cost, the gas selected is preferably argon. Selection of a metal such as copper, chromium, titanium, or aluminum for the material of the target 23, and selection of a gas such as nitrogen or oxygen for the reactive gas for the deposition of a thin film of nitride, oxide, or oxynitride of such metal on the surface of the long substrate is preferable in view of producing a particularly stable deposition of the film.

Such film deposition enables the deposition with reduced fouling of the surface of the target 23 and stable film deposition for a prolonged time with no disturbance in the film deposition speed and the film quality.

### Examples

Next, exemplary embodiments of the thin film formation using the plasma CVD apparatus E1, E2, or E3 as described above are described in detail.

### [Example 1]

A silicon oxide film was formed by using the plasma CVD apparatus E1 shown in FIG. 1 in the method for forming the silicon oxide film according to the first embodiment. The plasma during the formation of the silicon oxide film and the electrode after the film deposition were examined.

In the plasma CVD apparatus E1, the main roll 6 had a diameter of 500 mm and a width of 340 mm. The plasma generation electrode 7 was formed by combining a titanium plate having a length of 236 mm, a width of 80 mm, and a thickness of 6 mm and a SUS box having a length of 236 mm, a width of 80 mm, and a height of 30 mm. Cooling water was circulated in the SUS box for the cooling of the titanium plate. The side walls 8a and 8b had a thickness of 3 mm. The height of the side walls 8a and 8b measured from the surface of the plasma generation electrode 7 on the main roll side was 50 mm, and the length in transverse direction was 248 mm. The side wall in the upstream side in the machine direction (8a in FIG. 1) was formed with the row of gas supply holes 9. Each gas supply hole had a size of 0.5 mm, and 5 gas supply holes were formed at an interval of 45 mm with the margin from the opposite edges of 34 mm at a height from the plasma generation electrode 7 of 40 mm.

As shown in Table 1, the gas supply hole may preferably have a size of at least 0.1 mm and up to 3 mm in view of realizing a stable gas supply with no abnormal discharge in the hole and blockage of the hole by intrusion of foreign matters.

The side wall in the downstream side in the machine direction (8b in FIG. 1) was formed with the gas exhaust opening 10, and the exhaust opening was covered with a metal mesh. An MF band radio frequency power supply was connected to the plasma generation electrode 7, and each of the side walls 8a and 8b was grounded. A PET (polyethylene terephthalate) film was used for the long substrate.

In forming the silicon oxide film, the air in the vacuum chamber 1 was evacuated from the exhausting apparatus 12 to a pressure of less than 1 x 10⁻³ Pa, and a gas mixture of the source gas, oxygen, and Ar was introduced from the row of the gas supply holes 9. 0.1 g/min of HMDSO was vaporized in a vaporizer (not shown) by using 100 sccm of Ar (carrier gas) and this gas mixture was further mixed with 100 sccm of oxygen for use as the source gas. Interior in the vacuum chamber 1 was controlled to a pressure of 30 Pa by using an adjustment valve. The PET sheet was conveyed from the feed roll 2 to the takeup roll 3 at a velocity of 5 m/min while electricity (500 W) at a frequency of 100 kHz was supplied to the plasma generation electrode for plasma generation to thereby form a silicon oxide film on the surface of the PET sheet. The plasma during the formation of the silicon oxide film and the electrode after the formation of the silicon oxide film were observed.

As shown in Table 2, stable film deposition with no abnormal discharge could be conducted.

### [Example 2]

A silicon oxide film was formed by using the plasma CVD apparatus E2 shown in FIG. 4 in the method for forming the silicon oxide film according to the second embodiment. The plasma during the formation of the silicon oxide film and the electrode after the film deposition were examined. The row of the gas supply holes 9 for supplying the source gas was provided at the same position as the Example 1. Another row of gas supply holes 9 was formed at a position 9 mm from the row of the gas supply holes 9 for supplying the source gas on the side of the plasma discharge electrode 7, and Ar which was different from the carrier gas used was introduced from this row of the gas supply holes. 0.1 g/min of HMDSO was vaporized in a vaporizer (not shown) by using 50 sccm of Ar (carrier gas) and this gas mixture was further mixed with 100 sccm of oxygen for use as the source gas. 50 sccm of Ar in addition to the source gas was supplied from the lower row of the gas supply holes as described above. The procedure of Example 1 was repeated except for those as described above.

As shown in Table 2, stable film deposition with no abnormal discharge could be conducted. Contamination of the electrode after the film deposition was also reduced.

### [Example 3]

A silicon oxide film was formed by using the plasma CVD apparatus E3 shown in FIG. 5 in the method for forming the silicon oxide film according to the third embodiment, and the plasma during the deposition of the silicon oxide film and the electrode after the deposition of the silicon oxide film were observed. A neodymium magnet 16 having a width of 10 mm and a height of 15 mm was provided in the interior of the box of SUS in the plasma generation electrode 7, and cooling water was circulated in the cooling water pathway 17. The procedure of Example 2 was repeated for other aspects of this Example.

The film deposition speed was 45 nm x m/min without the magnet, and film deposition speed increased to 110 nm x m/min by the provision of the magnet. In addition, a stable film deposition with no abnormal discharge could be conducted as shown in Table 2. Contamination of the electrode after the film deposition was also reduced.

### [Example 4]

A silicon oxide film was formed by using the a plasma CVD apparatus wherein the electrode in the plasma CVD apparatus E1 shown in FIG. 1 had been changed to the electrode shown in FIG. 7 in the method for forming the silicon oxide film according to the first embodiment, and the plasma during the deposition of the silicon oxide film and the electrode after the deposition of the silicon oxide film were observed. The gas supply holes of the row of gas supply holes 9 were formed at the position gas holes of the side wall 8a, and the holes were completed by inserting an aluminum ceramics flanged collar having an inner diameter of 3 mm. The procedure of Example 1 was repeated for other aspects of this Example.

As shown in Table 2, a stable film deposition with no abnormal discharge could be conducted.

### [Comparative Example 1]

A silicon oxide film was formed by using a plasma CVD apparatus PA1 shown in FIG. 6. Plasma generation electrode P7 was the same as the one used in Example 1 to 3, and gas supply nozzle P8 had an inner diameter of 5 mm, and a pipe line P9 was formed from a copper pipe. Vacuum chamber P1, supply roll P2, takeup roll P3, guide roll P4, long substrate P5, main roll P6, and gas exhaust apparatus P10 were the same as those of Example 1.

As shown in Table 2, the discharge was unstable due to the entering of the plasma in the nozzle, and the abnormal discharge resulted in the generation of the particles in the nozzle and clogging of the nozzle by the particles. Deposition of the particles at the position opposing the nozzle was noted in the electrode after the film deposition.

Next, embodiments of forming the thin films by using the plasma CVD apparatus E4 as described above are described.

### [Example 5]

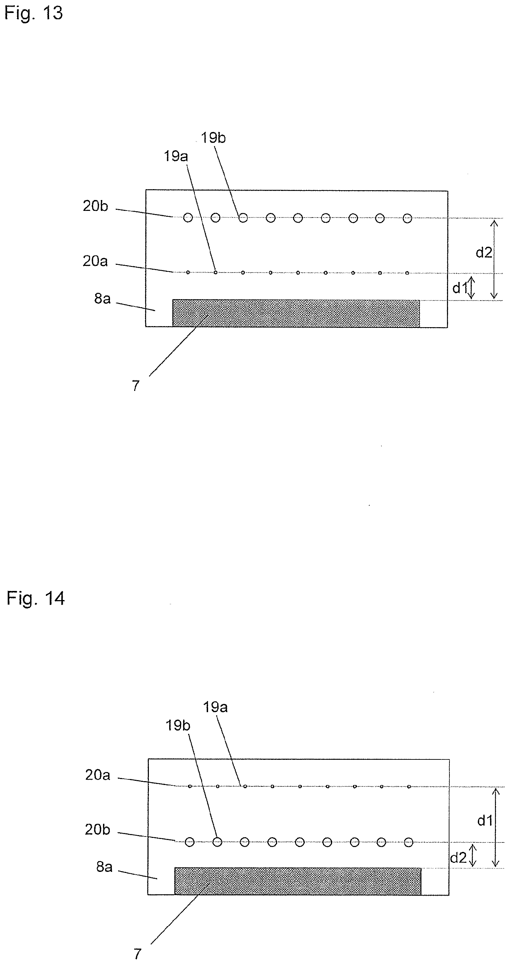

A thin film was formed by using a plasma CVD apparatus E4 shown in FIGS. 8 and 9. A PET film having a thickness of 100 µm was used for the long substrate 5. The distance between the surface of the plasma generation electrode 7 and the edge of the side wall 8a on the side of the main roll 6 was 5 cm, and the gap between the edge of the side wall 8a on the side of the main roll 6 and the main roll 6 was 1 mm. FIG. 13 is a schematic view of the side wall 8a on the upstream side in the machine direction of the long substrate 5. As shown in FIG. 13, the side wall 8a on the upstream side in the machine direction of the long substrate 5 was provided with a row of plasma generation-suppressing gas supply holes 20a comprising a plurality of small-diameter gas supply holes aligned in the direction of the transverse direction of the long substrate as a plasma generation-suppressing gas supply hole 19a, and a row of plasma generation-promoting gas supply holes 20b comprising a plurality of large-diameter gas supply holes aligned in the direction of the transverse direction of the long substrate as a plasma generation-promoting gas supply hole 19b. The distance d1 from the surface of the plasma generation electrode 7 to the row of the plasma generation-suppressing gas supply opening 20a, and the distance d2 from the surface of the plasma generation electrode 7 to the row of the plasma generation-promoting gas supply opening 20b were respectively 10 mm and 40 mm. The plasma generation-promoting gas supply holes 19b which were the gas supply opening provided nearest to the main roll 6 had an inner diameter of 5 mm. The plasma generation-suppressing gas supply hole 19a had an inner diameter of 0.5 mm. A exhaust opening 12 and a metal mesh 21 as shown in FIG. 10 was provided in the side wall 8b on the downstream side in the machine direction of the long substrate 5. In addition, as shown in FIG. 12, a central magnet 22a and a peripheral magnet 22b were provided in the interior of the plasma generation electrode 7, and a magnetron magnetic field was formed on the surface of the plasma generation electrode 7 by arranging the central magnet 22a and the peripheral magnet 22b so that they have a polarity.

The source gas used for the plasma CVD was HMDSO. The HMDSO which is the reactive gas was supplied at a flow rate of 10 sccm from the plasma generation-suppressing gas supply holes 19a together with 100 sccm of Ar which was the carrier gas. In addition, oxygen which was supplied as a non-reactive gas from the plasma generation-promoting gas supply hole 19b at a flow rate of 100 sccm. Pressure in the vacuum chamber was 30 Pa. The power supply used was a radio frequency power at a frequency of 100 kHz. An power of 500 W was supplied to the plasma generation electrode 7 while conveying the long substrate at a speed of 1 m/min for generation of the plasma to thereby form a thin film of SiOC on the surface of the long substrate 5. Stable generation of a high density plasma in the interior of the plasma generation-promoting gas supply hole 19b could be visually confirmed. The film thickness at this moment measured by a step gauge (ET-10 manufactured by Kosaka Laboratory Ltd.) was 120 nm, confirming the dramatic improvement in the film deposition speed.

### [Example 6]

In another embodiment of the side wall 8a shown in the schematic view of FIG. 14, the gas supply opening provided at the nearest position from the main roll 6 was used for the plasma generation-suppressing gas supply hole 19a. A SiOC thin film was formed on the surface of the long substrate 5 by repeating the procedure of Example 5 except that the distance d1 between the surface of the plasma generation electrode 7 and the row of the plasma generation-suppressing gas supply holes 20a and the distance d2 between the surface of the plasma generation electrode 7 and the row of the plasma generation-promoting gas supply holes 20b were respectively 40 mm and 10 mm. As in the case of Example 5, the HMDSO (polymerizable gas) and Ar (carrier gas) were supplied from the plasma generation-suppressing gas supply holes 19a, and oxygen (non-polymerizable gas) was supplied from the plasma generation-promoting gas supply holes 19b, and high density plasma was stably generated in the interior of the plasma generation-promoting gas supply hole 19b. The resulting film had a thickness of 85 nm, confirming the dramatic improvement in the film deposition speed. As shown in Table 2, contamination of the electrode after the film deposition was also reduced.

### [Example 7]

A SiOC thin film was formed on the surface of the long substrate 5 by repeating the procedure of Example 5 except that the inner diameter of the plasma generation-suppressing gas supply holes 19a was 0.15 mm. After the continuous film deposition for 30 minutes, plasma generation-suppressing gas supply holes 19a were examined. No trouble such as clogging was observed. The resulting film had a thickness of 115 nm, confirming the dramatic improvement in the film deposition speed.

### [Example 8]

A SiOC thin film was formed on the surface of the long substrate 5 by repeating the procedure of Example 5 except that the inner diameter of the plasma generation-suppressing gas supply holes 19a was 0.05 mm. After the continuous film deposition for 30 minutes, plasma generation-suppressing gas supply holes 19a were examined. While clogging was observed in some of the plasma generation-suppressing gas supply holes 19a, the resulting film had a thickness of 110 nm, confirming the dramatic improvement in the film deposition speed.

### [Example 9]

A SiOC thin film was formed on the surface of the long substrate 5 by repeating the procedure of Example 5 except that the inner diameter of the plasma generation-promoting gas supply holes 19b was 4.3 mm. Stable generation of high density plasma in the plasma generation-promoting gas supply holes 19b was confirmed. The resulting film had a thickness of 120 nm, also confirming the dramatic improvement in the film deposition speed.

### [Example 10]

A SiOC thin film was formed on the surface of the long substrate 5 by repeating the procedure of Example 5 except that the inner diameter of the plasma generation-suppressing gas supply holes 19a was 2.5 mm and pressure in the vacuum chamber was 20 Pa. Stable plasma generation with no abnormal discharge was confirmed. The resulting film had a thickness of 115 nm, also confirming the dramatic improvement in the film deposition speed.

### [Example 11]

A SiOC thin film was formed on the surface of the long substrate 5 by repeating the procedure of Example 5 except that the inner diameter of the plasma generation-promoting gas supply holes 19b was 3.7 mm. In spite of some blinking of a part of the high density plasma generated in the plasma generation-promoting gas supply holes 10b during the film deposition, the resulting film had a thickness of 110 nm, also confirming the dramatic improvement in the film deposition speed.

### [Example 12]

A SiOC thin film was formed on the surface of the long substrate 5 by repeating the procedure of Example 6 except that the inner diameter of the plasma generation-promoting gas supply holes 19b was 16 mm. In spite of weak plasma entering in the interior of the plasma generation-promoting gas supply holes 19b, the resulting film had a thickness of 70 nm, also confirming the dramatic improvement in the film deposition speed.

### [Comparative Example 2]

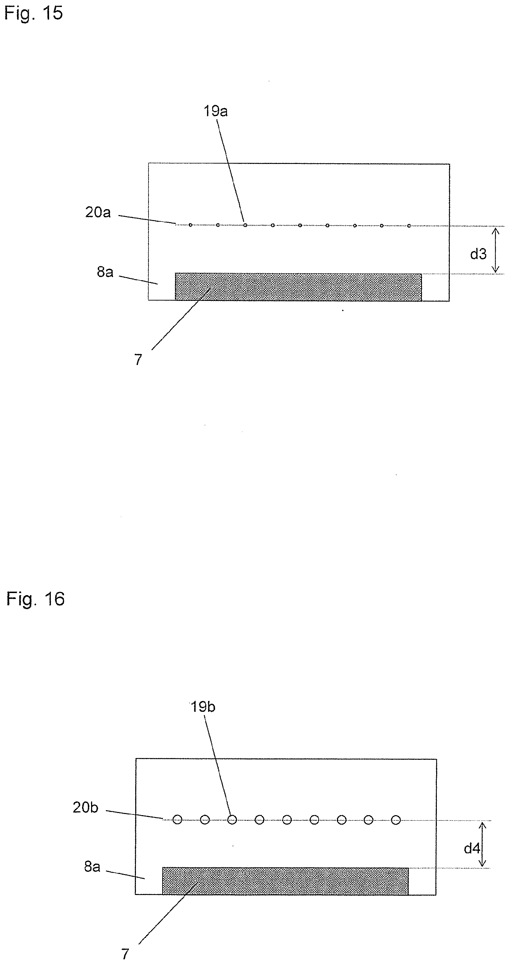

As shown in FIG. 15, the side wall 8a on the upstream side in the machine direction of the long substrate 5 used was the one provided with the row of the plasma generation-suppressing gas supply holes 20a wherein the plasma generation-suppressing gas supply holes 19a were aligned in the transverse direction of the long substrate direction. Distance d1 from the surface of the plasma generation electrode 7 to the row of the plasma generation-suppressing gas supply holes 20a was 2.5 cm. HMDSO (the reactive gas), Ar (the carrier gas), and oxygen (the non-polymerizable gas) were mixed and supplied from the row of plasma generation-suppressing gas supply holes 20a of FIG. 15. The gas supply holes 19a had an inner diameter of 0.5 mm. A SiOC thin film was formed on the surface of the long substrate 5 by using the conditions of Example 5 for other aspects of the production. The resulting film had a thickness of 50 nm.

### [Comparative Example 3]

As shown in FIG. 16, the side wall 8a on the upstream side in the machine direction of the long substrate 5 was the one provided with a row of the plasma generation-promoting gas supply opening 20b wherein plasma generation-promoting gas supply holes 19b were aligned in the transverse direction of the long substrate direction. Distance d4 from the surface of the plasma generation electrode 7 to the row of the plasma generation-suppressing gas supply holes 19a was 2.5 cm. HMDSO (the reactive gas), Ar (the carrier gas), and oxygen (the non-polymerizable gas) were mixed and supplied from the row of plasma generation-promoting gas supply holes 20b of FIG. 16. The gas supply holes 19b had an inner diameter of 0.5 mm. A SiOC thin film was formed on the surface of the long substrate 5 by using the conditions of Example 5 for other aspects of the production. In this process, a white deposition was gradually formed on the interior of the gas supply holes 19b with the plasma becoming unstable, and stable film deposition could not be carried out.

**[Table 1]**

| Gas hole diameter (mm) | Conditions of the gas-supply hole |
|---|---|
| 0.05 | B: capable of supplying the gas while holes are partially clogged by particles |
| 0.1 | A: good with no clogging |
| 0.5 | A: good with no clogging |
| 1 | A: good with no clogging |
| 3 | A: good with no clogging |
| 5 | B: abnormal discharge in some conditions |

**[Table 2-1]**

| Apparatus | Source gas supplying position (HMSDO) | O₂/Ar supplying position | Conditions of the apparatus |
|---|---|---|---|
| PA1 (Comparative Example 1) | Gas supplying tube (diameter, 5 mm) | | C: problems such as abnormal discharge in the tube, clogging of the tube with particles, deposition of powderly contaminants at the position corresponding to the tube |
| E1 (Example 1) | Row of the gas supply holes in the side wall (diameter, 0.5 mm) | | A: stable film deposition with no abnormal discharge |
| E2 (Example 2) | Row of the gas supply holes in the side wall (diameter, 0.5 mm) (upper row) | Row of the gas supply holes in the side wall (diameter, 0.5 mm) (lower row) | A: stable film deposition with no abnormal discharge, further reduction of electrode contamination |
| E3 (Example 3) | Row of the gas supply holes in the side wall (diameter, 0.5 mm) (upper row) | Row of the gas supply holes in the side wall (diameter, 0.5 mm) (lower row) | A: stable film deposition with no abnormal discharge, further reduction of electrode contamination |
| E1, FIG. 7 (Example 4) | Row of the insulated gas supply holes (diameter, 3 mm) | | A: stable film deposition with no abnormal discharge |
| E4, FIG. 13 (Example 5) | Row of the plasma generation-suppressing gas supply holes (diameter, 0.5 mm) (lower row) | Row of the plasma generation-promoting gas supply holes (diameter, 5 mm) (upper row) | A: stable film deposition with no abnormal discharge |
| E4, FIG. 14 (Example 6) | Row of the plasma generation-suppressing gas supply holes (diameter, 0.5 mm) (upper row) | Row of the plasma generation-promoting gas supply holes (diameter, 5 mm) (lower row) | A: stable film deposition with no abnormal discharge, further reduction of electrode contamination |

**[Table 2-2]**

| Apparatus | Source gas supplying position (HMSDO) | O₂/Ar supplying position | Conditions of the apparatus |
|---|---|---|---|
| E4, (Example 7) | Row of the plasma generation-suppressing gas supply holes (diameter, 0.15 mm) (lower row) | Row of the plasma generation-promoting gas supply holes (diameter, 5 mm) (upper row) | A: stable film deposition with no abnormal discharge |
| E4, (Example 8) | Row of the plasma generation-suppressing gas supply holes (diameter, 0.05 mm) (lower row) | Row of the plasma generation-promoting gas supply holes (diameter, 5 mm) (upper row) | B: no abnormal discharge with sign of clogging in the plasma generation-suppressing gas supply holes |
| E4, (Example 9) | Row of the plasma generation-suppressing gas supply holes (diameter, 0.5 mm) (lower row) | Row of the plasma generation-promoting gas supply holes (diameter, 4.3 mm) (upper row) | A: stable film deposition with no abnormal discharge |
| E4, (Example 10) | Row of the plasma generation-suppressing gas supply holes (diameter, 2.5 mm) (lower row) | Row of the plasma generation-promoting gas supply holes (diameter, 5 mm) (upper row) | A: stable film deposition with no abnormal discharge |
| E4, (Example 11) | Row of the plasma generation-suppressing gas supply holes (diameter, 0.5 mm) (lower row) | Row of the plasma generation-promoting gas supply holes (diameter, 3.7 mm) (upper row) | B: some blinking confirmed in the row of the plasma generation-promoting gas supply holes |
| E4, (Example 12) | Row of the plasma generation-suppressing gas supply holes (diameter, 0.5 mm) (upper row) | Row of the plasma generation-promoting gas supply holes (diameter, 16 mm) (lower row) | B: weak plasma generation in the row of the plasma generation-promoting gas supply holes, reduced electrode contamination |

**[Table 2-3]**

| Apparatus | Source gas supplying position (HMSDO) | O₂/Ar supplying position | Conditions of the apparatus |
|---|---|---|---|
| FIG. 15 (Comparative Example 2 | Row of the plasma generation-suppressing gas supply holes (diameter, 0.5 mm) (upper row) | | A: no abnormal discharge |
| FIG. 16 (Comparative Example 3) | Row of the plasma generation-promoting gas supply holes (diameter, 5 mm) (lower row) | | C: unstable plasma and deposition in the gas supply holes |

### Industrial Applicability

Use of the plasma CVD apparatus of the present invention is favorable for the formation of a thin film with consistent high film quality due to the reduced abnormal discharge. The plasma treatment apparatus of the present invention can also be used as an etching apparatus or a plasma surface modifying apparatus.

### Explanation of Numerals

- 1:: vacuum chamber
- 2:: feed roll
- 3:: takeup roll
- 4:: guide roll
- 5:: long substrate
- 6:: main roll
- 7:: plasma generation electrode
- 8a, 8b:: side wall
- 9, 9a, 9b:: row of gas supply holes
- 10:: gas exhaust opening
- 11:: power supply
- 12:: gas exhaust apparatus
- 13:: insulator
- 14a, 14b:: gas tube
- 15a, 15b:: gas pipe
- 16:: magnet
- 17:: cooling water pathway
- 18:: row of insulated gas supply holes
- 19a:: plasma generation-suppressing gas supply hole
- 19b:: plasma generation-promoting gas supply hole
- 20a:: row of the plasma generation-suppressing gas supply holes
- 20b:: row of the plasma generation-promoting gas supply holes
- 21:: gas exhaust hole
- 22a:: central magnet
- 22b:: peripheral magnet
- 23:: target
- 24:: magnetron electrode
- 25:: gas distributing plate
- E1, E2, E3, E4, PA1:: plasma CVD apparatus
- E5, E6, E7:: reactive sputtering apparatus
- P1:: vacuum chamber
- P2:: feed roll
- P3:: takeup roll
- P4:: guide roll
- P5:: long substrate
- P6:: main roll
- P7:: plasma generation electrode
- P8:: nozzle
- P9:: pipe line
- P10:: gas exhaust apparatus

## Claims

1. A plasma CVD apparatus (E1, E2, E3, E4) comprising a vacuum chamber (1), and a main roll (6) and a plasma generation electrode (7) in the vacuum chamber (1), wherein a thin film is formed on a surface of a long substrate (5) which is conveyed along the surface of the main roll (6), wherein
at least one side wall (8a, 8b) extending in transverse direction of the long substrate (5) is provided on each of the upstream and downstream sides in the machine direction of the long substrate (5), and the side walls (8a, 8b) surrounds the film deposition space between the main roll and the plasma generation electrode (7), and
the side walls (8a, 8b)are electrically insulated from the plasma generation electrode (7), **characterized in that**
the side wall (8a, 8b) on either the upstream or the downstream side in the machine direction of the long substrate (5) is provided with a gas supply hole (9, 9a, 9b), the gas supply hole (9, 9a, 9b) is in the form of at least one row of gas supply holes aligned in the transverse direction of the long substrate, and
the side wall (8a, 8b) on either the upstream or the downstream side in the machine direction of the long substrate (5) which is not the one provided with the gas supply hole (9, 9a, 9b) is provided with a gas exhaust opening (10), and the gas exhaust opening (10) has a plurality of gas exhaust holes.

2. A plasma CVD apparatus (E1, E2, E3, E4) according to claim 1 wherein the row of the gas supply holes (9, 9a, 9b) is provided in the side wall (8a) on the upstream side in the machine direction of the long substrate (5), and the gas exhaust opening (10) is provided in the side wall (8b) on the downstream side in the machine direction of the long substrate (5).

3. A plasma CVD apparatus (E1, E2, E3, E4) according to claim 1 or 2 wherein at least two rows of the gas supply holes (9, 9a, 9b) are provided, and at least the row of the gas supply holes (9, 9a, 9b) nearest to the plasma generation electrode (7) is capable of supplying a gas different from the gas supplied by other row(s) of the gas supply holes (9, 9a, 9b).

4. A plasma CVD apparatus (E1, E2, E3, E4) according to any one of claims 1 to 3 wherein a magnet (16) for generating magnetic flux on the surface of the plasma generation electrode (7) is in the plasma generation electrode (7).

5. A plasma CVD method conducted by using the plasma CVD apparatus (E1, E2, E3, E4) of any one of claims 1 to 4 comprising the steps of supplying a source gas from the gas supply hole or the row of the gas supply holes (9, 9a, 9b), and generating the plasma from the plasma generating electrode (7) to form a thin film on the long substrate (5) being conveyed.

6. A plasma CVD method conducted by using the plasma CVD apparatus (E1, E2, E3, E4) of claim 3 wherein the gas supplied from at least the row of the gas supply holes (9, 9a, 9b) nearest to the plasma generation electrode (7) is different from the gas supplied by other row(s) of the gas supply holes (9, 9a, 9b).

7. A plasma CVD method conducted by using the method of claim 6 wherein the gas supplied from the row of the gas supply holes (9, 9a, 9b) nearest to the plasma generation electrode (7) is only a non-reactive gas, and a gas containing Si atom or C atom in the molecule is supplied from at least one of other rows of the gas supply holes (9, 9a, 9b), and plasma is generated by the plasma generation electrode (7) to thereby form a thin film on the long substrate (5) being conveyed.

## Patentansprüche

1. Plasma-CVD-Vorrichtung (E1, E2, E3, E4), die eine Vakuumkammer (1), und eine Hauptwalze (6) und eine Plasmaerzeugungselektrode (7) in der Vakuumkammer (1) aufweist, wobei ein dünner Film auf einer Oberfläche eines langen Substrats (5) ausgebildet wird, das entlang der Oberfläche der Hauptwalze (6) gefördert wird, wobei
jeweils mindestens eine sich in Querrichtung des langen Substrats (5) erstreckende Seitenwand (8a, 8b) an den in Maschinenrichtung des langen Substrats (5) stromaufwärts und stromabwärts gelegenen Seiten vorgesehen ist, und die Seitenwände (8a, 8b) den Filmablagerungsraum zwischen der Hauptwalze und der Plasmaerzeugungselektrode (7) umgeben, und
die Seitenwände (8a, 8b) gegenüber der Plasmaerzeugungselektrode (7) elektrisch isoliert sind,
die Seitenwand (8a, 8b) entweder auf der stromaufwärts oder der stromabwärts gelegenen Seite in Maschinenrichtung des langen Substrats (5) mit einem Gaszufuhrloch (9, 9a, 9b) versehen ist, wobei das Gaszufuhrloch (9, 9a, 9b) in Form von mindestens einer Reihe von Gaszufuhrlöchern vorliegt, die in Querrichtung des langen Substrats ausgerichtet ist, und
die Seitenwand (8a, 8b) entweder auf der stromaufwärts oder der stromabwärts gelegenen Seite in Maschinenrichtung des langen Substrats (5), die nicht mit dem Gaszufuhrloch (9, 9a, 9b) versehen ist, mit einer Gasauslassöffnung (10) versehen ist, und die Gasauslassöffnung (10) eine Vielzahl von Gasauslasslöchern aufweist.

2. Plasma-CVD-Vorrichtung (E1, E2, E3, E4) nach Anspruch 1, wobei die Reihe der Gaszufuhrlöcher (9, 9a, 9b) in der Seitenwand (8a) auf der stromaufwärts gelegenen Seite in Maschinenrichtung des langen Substrats (5) vorgesehen ist, und die Gasauslassöffnung (10) in der Seitenwand (8b) auf der stromabwärts gelegenen Seite in Maschinenrichtung des langen Substrats (5) vorgesehen ist.

3. Plasma-CVD-Vorrichtung (E1, E2, E3, E4) nach Anspruch 1 oder 2, wobei mindestens zwei Reihen der Gaszufuhrlöcher (9, 9a, 9b) vorgesehen sind, und mindestens die Reihe der Gaszufuhrlöcher (9, 9a, 9b), die der Plasmaerzeugungselektrode (7) am nächsten ist, ein Gas zuführen kann, das sich von dem Gas unterscheidet, das von einer anderen Reihe/anderen Reihen der Gaszufuhrlöcher (9, 9a, 9b) zugeführt wird.

4. Plasma-CVD-Vorrichtung (E1, E2, E3, E4) nach einem der Ansprüche 1 bis 3, wobei sich ein Magnet (16) zum Erzeugen eines Magnetflusses auf der Oberfläche der Plasmaerzeugungselektrode (7) in der Plasmaerzeugungselektrode (7) befindet.

5. Plasma-CVD-Verfahren, durchgeführt unter Verwendung der Plasma-CVD-Vorrichtung (E1, E2, E3, E4) nach einem der Ansprüche 1 bis 4, umfassend die Schritte des Zuführens eines Quellgases aus dem Gaszufuhrloch oder der Reihe der Gaszufuhrlöcher (9, 9a, 9b), und Erzeugen des Plasmas von der Plasmaerzeugungselektrode (7), um einen dünnen Film auf dem langen Substrat (5) zu bilden, das gefördert wird.

6. Plasma-CVD-Verfahren, durchgeführt unter Verwendung der Plasma-CVD-Vorrichtung (E1, E2, E3, E4) nach Anspruch 3, wobei das Gas, das von mindestens der Reihe der Gaszufuhrlöcher (9, 9a, 9b) zugeführt wird, die der Plasmaerzeugungselektrode (7) am nächsten ist, sich von dem Gas unterscheidet, das von einer anderen Reihe/anderen Reihen der Gaszufuhrlöcher (9, 9a, 9b) zugeführt wird.

7. Plasma-CVD-Verfahren, durchgeführt unter Verwendung des Verfahrens nach Anspruch 6, wobei das Gas, das von der Reihe der Gaszufuhrlöcher (9, 9a, 9b) zugeführt wird, die der Plasmaerzeugungselektrode (7) am nächsten ist, nur ein nicht-reaktives Gas ist, und ein Gas, das ein Si-Atom oder ein C-Atom im Molekül enthält, von mindestens einer der anderen Reihen der Gaszufuhrlöcher (9, 9a, 9b) zugeführt wird, und Plasma durch die Plasmaerzeugungselektrode (7) erzeugt wird, um dadurch einen dünnen Film auf dem langen Substrat (5) zu bilden, das gefördert wird.

## Revendications

1. Dispositif CVD assisté par plasma (E1, E2, E3, E4) comprenant une chambre à vide (1), et un rouleau principal (6) et une électrode de génération de plasma (7) dans la chambre à vide (1), dans lequel un film mince est formé sur une surface d'un substrat long (5) qui est transporté le long de la surface du rouleau principal (6), dans lequel
au moins une paroi latérale (8a, 8b) s'étendant dans une direction transversale du substrat long (5) est prévue sur chacun des côtés amont et aval dans la direction machine du substrat long (5), et les parois latérales (8a, 8b) entourent l'espace de dépôt de film entre le rouleau principal et l'électrode de génération de plasma (7), et
les parois latérales (8a, 8b) sont isolées électriquement de l'électrode de génération de plasma (7), **caractérisé en ce que**
la paroi latérale (8a, 8b) du côté amont ou du côté aval dans la direction machine du substrat long (5) est munie d'un trou d'alimentation en gaz (9, 9a, 9b), le trou d'alimentation en gaz (9, 9a, 9b) est sous la forme d'au moins une rangée de trous d'alimentation en gaz alignés dans la direction transversale du substrat long, et
la paroi latérale (8a, 8b) du côté amont ou du côté aval dans la direction machine du substrat long (5) qui n'est pas celle munie du trou d'alimentation en gaz (9, 9a, 9b) est munie d'une ouverture d'échappement de gaz (10), et l'ouverture d'échappement de gaz (10) a une pluralité de trous d'échappement de gaz.

2. Dispositif CVD assisté par plasma (E1, E2, E3, E4) selon la revendication 1, dans lequel la rangée des trous d'alimentation en gaz (9, 9a, 9b) est prévue dans la paroi latérale (8a) du côté amont dans la direction machine du substrat long (5), et l'ouverture d'échappement de gaz (10) est prévue dans la paroi latérale (8b) du côté aval dans la direction machine du substrat long (5).

3. Dispositif CVD assisté par plasma (E1, E2, E3, E4) selon la revendication 1 ou 2, dans lequel au moins deux rangées des trous d'alimentation en gaz (9, 9a, 9b) sont prévues, et au moins la rangée des trous d'alimentation en gaz (9, 9a, 9b) la plus proche de l'électrode de génération de plasma (7) est capable de fournir un gaz différent du gaz fourni par d'autre(s) rangée(s) des trous d'alimentation en gaz (9, 9a, 9b).

4. Dispositif CVD assisté par plasma (E1, E2, E3, E4) selon l'une quelconque des revendications 1 à 3, dans lequel un aimant (16) de génération de flux magnétique sur la surface de l'électrode de génération de plasma (7) se trouve dans l'électrode de génération de plasma (7).

5. Procédé CVD assisté par plasma conduit en utilisant le dispositif CVD assisté par plasma (E1, E2, E3, E4) de l'une quelconque des revendications 1 à 4, comprenant les étapes de fourniture d'un gaz source à partir du trou d'alimentation en gaz ou de la rangée des trous d'alimentation en gaz (9, 9a, 9b), et de génération du plasma à partir de l'électrode de génération de plasma (7) pour former un film mince sur le substrat long (5) transporté.

6. Procédé CVD assisté par plasma conduit en utilisant le dispositif CVD assisté par plasma (E1, E2, E3, E4) de la revendication 3, dans lequel le gaz fourni à partir d'au moins la rangée des trous d'alimentation en gaz (9, 9a, 9b) la plus proche de l'électrode de génération de plasma (7) est différent du gaz fourni par d'autre(s) rangée(s) des trous d'alimentation en gaz (9, 9a, 9b).

7. Procédé CVD assisté par plasma conduit en utilisant le procédé de la revendication 6, dans lequel le gaz fourni à partir de la rangée des trous d'alimentation en gaz (9, 9a, 9b) la plus proche de l'électrode de génération de plasma (7) est uniquement un gaz non réactif, et un gaz contenant un atome de Si ou un atome de C dans la molécule est fourni à partir d'au moins l'une des autres rangées des trous d'alimentation en gaz (9, 9a, 9b), et le plasma est généré par l'électrode de génération de plasma (7) pour former ainsi un film mince sur le substrat long (5) transporté.
